# EUROPEAN PATENT APPLICATION

(11) **EP 4 478 404 A1**
(43) Date of publication of application: **18.12.2024**
(21) Application number: 24152542.7
(22) Date of filing: 18.01.2024
(51) Int. Cl.: H01L 21/768, H01L 23/48, H01L 23/528

(54) **INTEGRATED CIRCUIT DEVICE**

(30) Priority: 14.06.2023 KR 20230076422
(71) Applicant: Samsung Electronics Co., Ltd., Suwon-si, Gyeonggi-do 16677 (KR)
(72) Inventor: Minchul, AHN, 16677 Suwon-si (KR); KIM, Yeonggil, 16677 Suwon-si (KR); PARK, Sungbin, 16677 Suwon-si (KR); JUNG, Deokyoung, 16677 Suwon-si (KR)
(74) Representative: Marks & Clerk LLP

(57) **Abstract**

An integrated circuit device includes a backside insulating structure including an etch stop pattern, gate lines arranged over the backside insulating structure and each overlapping the etch stop pattern in a vertical direction, source/drain regions respectively arranged one-by-one between the gate lines, and a backside via contact passing through the etch stop pattern in the vertical direction and connected to a first source/drain region selected from the source/drain regions, wherein the backside via contact includes a stepped portion, which is apart from a first vertical level in the vertical direction by as much as a first distance and has a change in the width of the backside via contact in a horizontal direction at a second vertical level that is adjacent to the etch stop pattern, the first vertical level being closest to the plurality of gate lines in the backside insulating structure.

## Description

### TECHNICAL FIELD

The present invention generally relates to an integrated circuit device.

### BACKGROUND

Various example embodiments relate to an integrated circuit device, and more particularly, to an integrated circuit device including a backside contact structure.

Due to the advance of electronics technology, integrated circuit devices have been rapidly down-scaled. Because highly down-scaled integrated circuit devices require or expect the accuracy in operations as well as high operation speeds, there is a need or desire to provide a wiring structure, which includes conductive lines having a more stable and/or improved or optimized arrangement structure in a relatively small area, and/or an insulating structure for preventing or reducing the likelihood of an unintended short-circuit between a plurality of conductive regions.

### SUMMARY

According to the present invention, there is provided an integrated circuit device as defined by claim 1. Preferred embodiments are defined by the dependent claims.

### BRIEF DESCRIPTION OF THE DRAWINGS

Various example embodiments will be more clearly understood from the following detailed description taken in conjunction with the accompanying drawings in which:
FIG. 1 is a schematic plan view of an example of a cell block of an integrated circuit device, according to some example embodiments;
FIG. 2 is a planar layout diagram illustrating an integrated circuit device according to some example embodiments;
FIG. 3A is a cross-sectional view of the integrated circuit device, taken along a line X1-X1' of FIG. 2;
FIG. 3B is a cross-sectional view of the integrated circuit device, taken along a line Y1-Y1' of FIG. 2;
FIG. 3C is a cross-sectional view of the integrated circuit device, taken along a line Y2-Y2' of FIG. 2;
FIGS. 4 and 5 are cross-sectional views respectively illustrating integrated circuit devices according to some example embodiments;
FIGS. 6A to 6C are cross-sectional views of an integrated circuit device according to some example embodiments;
FIGS. 7 and 8 are cross-sectional views respectively illustrating integrated circuit devices according to some example embodiments;

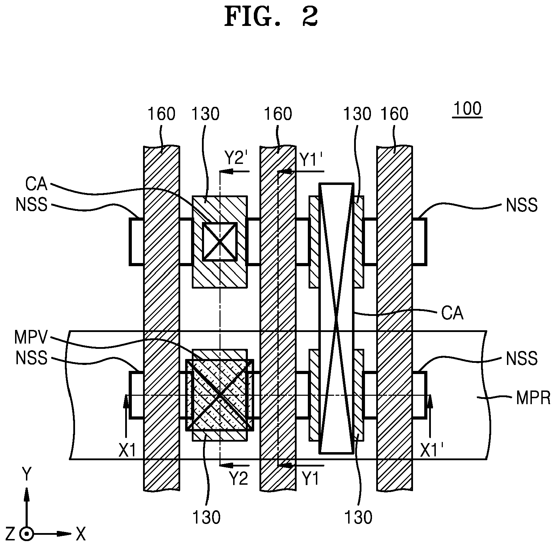

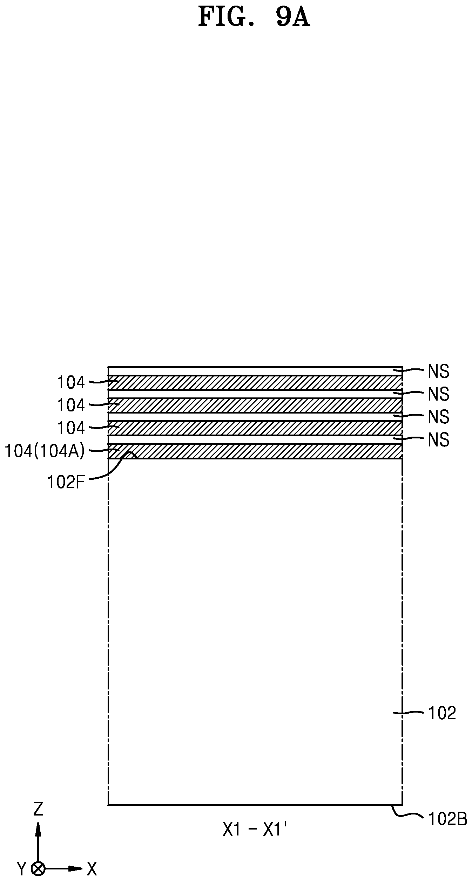

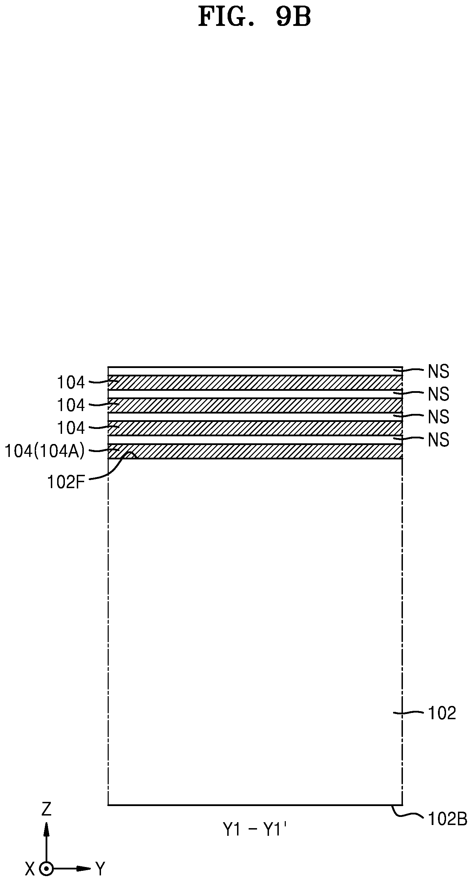

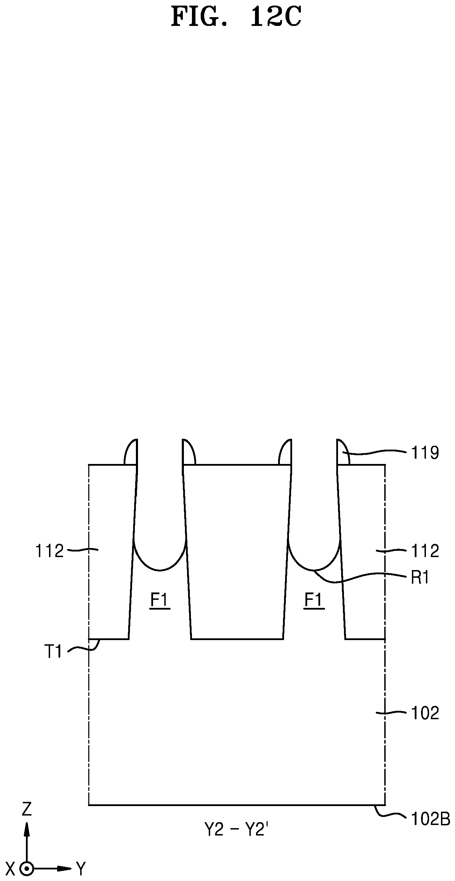

FIGS. 9A to 24C are diagrams respectively illustrating a sequence of processes of a method of fabricating an integrated circuit device, according to some example embodiments, and in particular, FIGS. 9A, 10A, 11A, 12A, 13A, 14A, 15A, 16A, 17A, 18A, 19A, 20A, 21A, 22A, 23A, and 24A are cross-sectional views each illustrating an example of a cross-sectional structure of a portion of the integrated circuit device, which corresponds to the cross-section taken along the line X1-X1' of FIG. 2, according to the sequence of processes, FIGS. 9B, 10B,11B, 12B, 13B, 14B, 15B, 16B, 17B, 18B, 19B, 20B, 21B, 22B, 23B, and 24B are cross-sectional views each illustrating an example of a cross-sectional structure of a portion of the integrated circuit device, which corresponds to the cross-section taken along the line Y1-Y1' of FIG. 2, according to the sequence of processes, and FIGS. 12C, 13C, 18C, 19C, 20C, 21C, 22C, 23C, and 24C are cross-sectional views each illustrating an example of a cross-sectional structure of a portion of the integrated circuit device, which corresponds to the cross-section taken along the line Y2-Y2' of FIG. 2, according to the sequence of processes; and

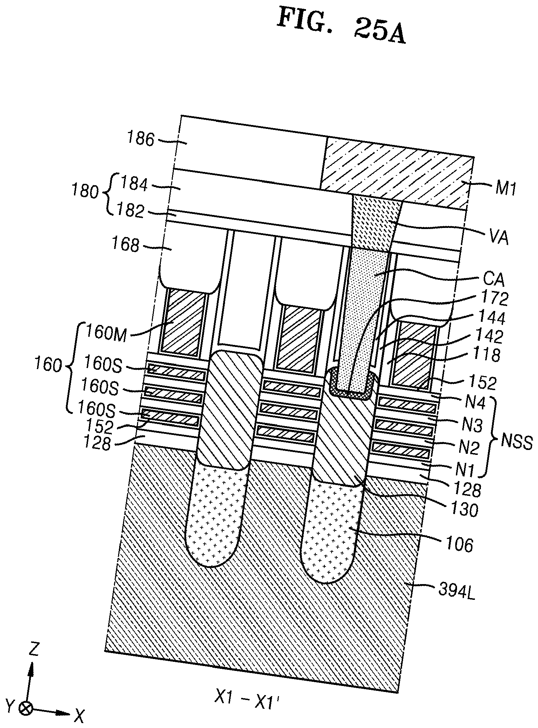

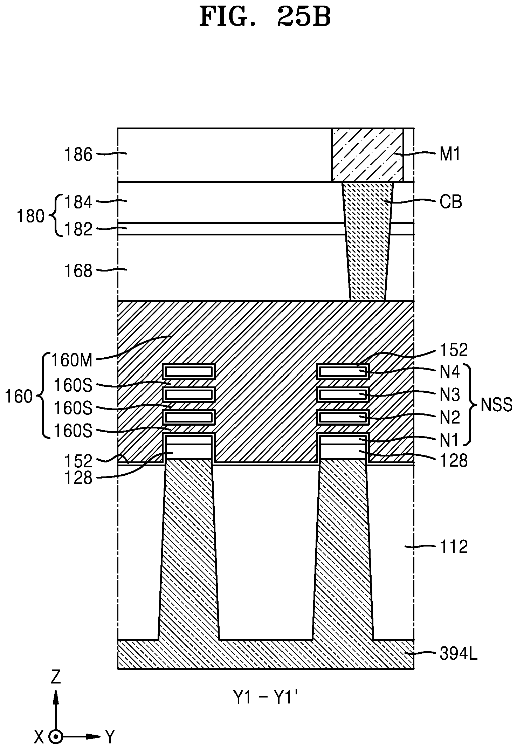

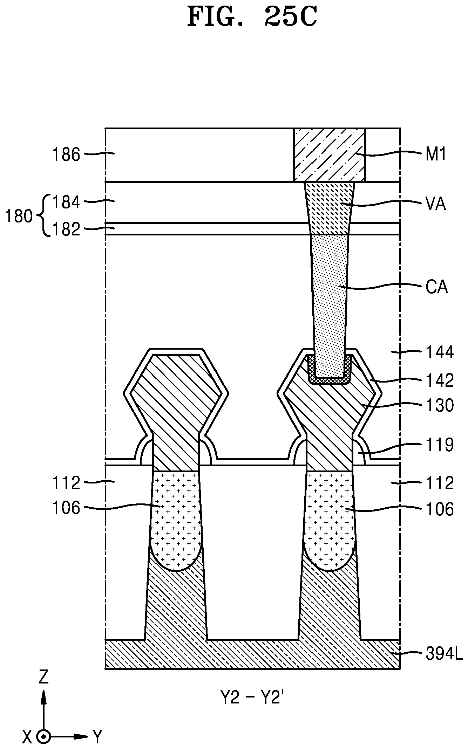

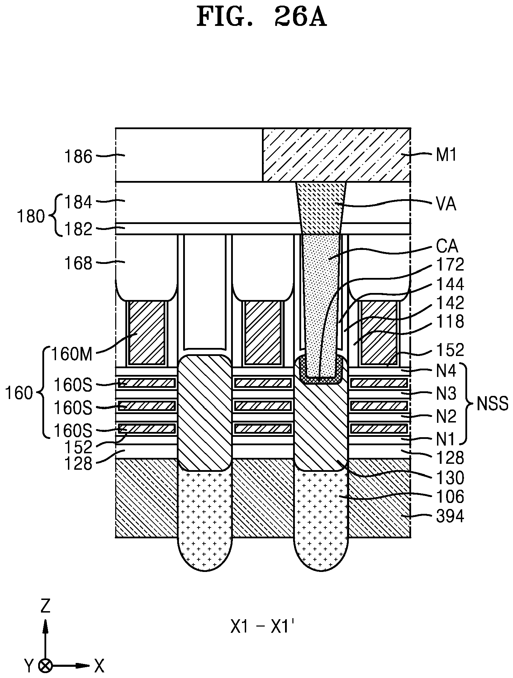

FIGS. 25A to 29C are diagrams respectively illustrating a sequence of processes of a method of fabricating an integrated circuit device, according to some example embodiments, and in particular, FIGS. 25A, 26A, .27A, 28A, and 29A are cross-sectional views each illustrating an example of a cross-sectional structure of a portion of the integrated circuit device, which corresponds to the cross-section taken along the line X1-X1' of FIG. 2, according to the sequence of processes, FIGS. 25B, 26B, 27B, 28B, and 29B are cross-sectional views each illustrating an example of a cross-sectional structure of a portion of the integrated circuit device, which corresponds to the cross-section taken along the line Y1-Y1' of FIG. 2, according to the sequence of processes, and FIGS. 25C, 26C, 27C, 28C, and 29C are cross-sectional views each illustrating an example of a cross-sectional structure of a portion of the integrated circuit device, which corresponds to the cross-section taken along the line Y2-Y2' of FIG. 2, according to the sequence of processes.

### DETAILED DESCRIPTION OF VARIOUS EMBODIMENTS

Various example embodiments provide an integrated circuit device having a structure with improved reliability by securing or helping to secure sufficient insulating distances between conductive regions and thus advantageously preventing or reducing the likelihood of an unintended short-circuit between a plurality of conductive regions when the integrated circuit device includes a plurality of wiring structures arranged in an area that has been reduced due to down-scaling.

According to some example embodiments, there is provided an integrated circuit device including a backside insulating structure including an etch stop pattern, a plurality of gate lines over the backside insulating structure and each at least partly overlapping the etch stop pattern in a vertical direction, a plurality of source/drain regions respectively arranged one-by-one between the plurality of gate lines, and a backside via contact passing through the etch stop pattern in the vertical direction and connected to a first source/drain region selected from the plurality of source/drain regions,. The backside via contact includes a stepped portion, which is apart from a first vertical level in the vertical direction by as much as a first distance and has a change in the width of the backside via contact in a horizontal direction at a second vertical level that is adjacent to the etch stop pattern, the first vertical level being closest to the plurality of gate lines in the backside insulating structure.

Alternatively or additionally according to some example embodiments, there is provided an integrated circuit device including a backside insulating structure, a plurality of channel regions over the backside insulating structure, the plurality of channel regions arranged apart from each other in a vertical direction to overlap each other in the vertical direction, a pair of source/drain regions over the backside insulating structure and each contacting the plurality of channel regions, a gate line surrounding the plurality of channel regions, and a backside via contact passing through the backside insulating structure in the vertical direction and connected to a first source/drain region selected from the pair of source/drain regions,. The backside insulating structure includes an etch stop pattern and an outer backside insulating pattern, the etch stop pattern surrounding a portion of the backside via contact and overlaps the gate line in the vertical direction, the outer backside insulating pattern surrounding another portion of the backside via contact and apart from the gate line in the vertical direction with the etch stop pattern therebetween, the outer backside insulating pattern including a different material from any constituent material of the etch stop pattern. The backside via contact includes a stepped portion, which is apart from a first vertical level in the vertical direction by as much as a first distance and has a change in the width of the backside via contact in a horizontal direction at a second vertical level that is adjacent to the etch stop pattern, the first vertical level being closest to the plurality of gate lines in the backside insulating structure.

Alternatively or additionally, there is provided an integrated circuit device including a backside insulating structure including an etch stop pattern and a backside insulating pattern, which include different materials from each other and which at least partly overlap each other in a vertical direction, a plurality of source/drain regions over the backside insulating structure, a plurality of nanosheet stacks, which each include at least one nanosheet connected to at least one source/drain region selected from the plurality of source/drain regions, a plurality of gate lines over the backside insulating structure, each of the plurality of gate lines surrounding the at least one nanosheet and at least partly overlapping the etch stop pattern in the vertical direction, a backside via contact passing through the etch stop pattern and the backside insulating pattern in the vertical direction and connected to a first source/drain region selected from the plurality of source/drain regions, and a place holder, which is in contact with a second source/drain region selected from the plurality of source/drain regions and faces the backside via contact in a horizontal direction with the backside insulating structure therebetween. The backside via contact includes a stepped portion, which is apart from a first vertical level and has a change in the width of the backside via contact in a horizontal direction at a vertical level that is adjacent to the etch stop pattern, the first vertical level being closest to the plurality of gate lines in the backside insulating structure.

It is noted that the term "source/drain" as used herein generally means "either source or drain". Thus, a "plurality of source/drain regions" may comprise two or more regions, each of which is either a source region or drain region.

It is further noted that the terms "horizontal" and "vertical" are used herein relative to each other and do not imply any particular orientation of a device. Generally, "horizontal" may mean substantially (eg exactly) parallel to a backside and/or topside surface of a device and "vertical" may mean substantially perpendicular to such a backside and/or topside surface.

It is further noted that the term "as much as" as used thoughout is optional and thus may be disregarded for some embodiments.

Hereinafter, embodiments of the inventive concept will be described in detail with reference to the accompanying drawings. Like components are denoted by like reference numerals throughout the specification, and repeated descriptions thereof are omitted.

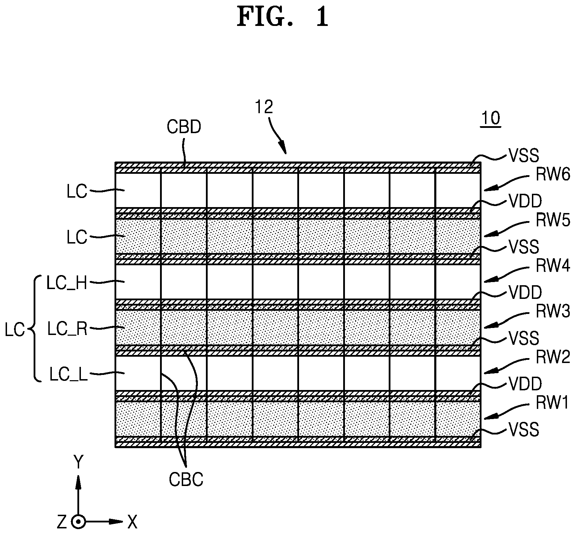

FIG. 1 is a schematic plan view of an example of a cell block 12 of an integrated circuit device 10 according to some example embodiments.

Referring to FIG. 1, the cell block 12 of the integrated circuit device 10 may include a plurality of cells LC including circuit patterns for constituting various circuits. The plurality of cells LC may be arranged in a matrix in the width direction (X direction in FIG. 1) and the height direction (Y direction in FIG. 1) in the cell block 12. The X direction and the Y direction may define a plane, e.g., a plane that is parallel to a surface of a substrate; example embodiments are not limited thereto.

The plurality of cells LC may include a circuit pattern having a layout designed by a Place and Route (PnR) technique to perform at least one logical function. The plurality of cells LC may perform various logical functions. In some example embodiments, the plurality of cells LC may include a plurality of standard cells. In some example embodiments, at least some of the plurality of cells LC may perform the same logical function. In some example embodiments, at least some of the plurality of cells LC may perform different logical functions from each other.

The plurality of cells LC may include various types of logic cells including a plurality of circuit elements. For example, each of the plurality of cells LC may include, but is not limited to, one or more of an AND, a NAND, an OR, a NOR, an exclusive OR (XOR), an exclusive NOR (XNOR), an inverter (INV), an adder (ADD), a buffer (BUF), a delay (DLY), a filter (FIL), a multiplexer (MXT/MXIT), an OR/AND/INVERTER (OAI), an AND/OR (AO), an AND/OR/INVERTER (AOI), a D flip-flop, a reset flip-flop, a master-slave flip-flop, a latch, or a combination thereof.

In the cell block 12, at least some of the plurality of cells LC constituting one row (e.g., RW1, RW2, RW3, RW4, RW5, or RW6) in the width direction (X direction in FIG. 1) may have the same width. Alternatively or additionally, at least some of the plurality of cells LC constituting one row (e.g., RW1, RW2, RW3, RW4, RW5, or RW6) may have the same height (e.g., height in a direction horizontal to a plane defined. However, example embodiments are not limited to the example shown in FIG. 1, and at least some of the plurality of cells LC constituting one row (that is, RW1, RW2, RW3, RW4, RW5, or RW6) may have different widths and/or heights from each other.

The area of each of the plurality of cells LC in the cell block 12 of the integrated circuit device 10 may be defined by a cell boundary CBD. A cell interface portion CBC, at which respective cell boundaries CBD meet each other, may be arranged between two adjacent cells LC in the width direction (X direction in FIG. 1) or the height direction (Y direction in FIG. 1) from among the plurality of cells LC.

In some example embodiments, two adjacent cells LC in the width direction from among the plurality of cells LC constituting one row (that is, RW1, RW2, RW3, RW4, RW5, or RW6) may be in contact with each other at the cell interface portion CBC without a separation distance therebetween. In some example embodiments, two adjacent cells LC in the width direction from among the plurality of cells LC constituting one row (for examples, RW1, RW2, RW3, RW4, RW5, or RW6) may be apart from each other with a certain separation distance (the same or different distances) therebetween.

In some example embodiments, in the plurality of cells LC constituting one row (that is, RW1, RW2, RW3, RW4, RW5, or RW6), two adjacent cells LC may perform the same function. In this case, the two adjacent cells LC may have the same structure. In some example embodiments, in the plurality of cells LC constituting one row (that is, RW1, RW2, RW3, RW4, RW5, or RW6), two adjacent cells LC may perform different functions from each other.

In some example embodiments, one cell LC selected from the plurality of cells LC, which are included in the cell block 12 of the integrated circuit device 10, and another cell LC adjacent to the selected cell LC in the height direction (Y direction in FIG. 1) may have symmetric structures to each other about the cell interface portion CBC therebetween. For example, a reference logic cell LC_R in the third row RW3 and a lower logic cell LC_L in the second row RW2 may have symmetric structures to each other about the cell interface portion CBC therebetween. Alternatively or additionally, the reference logic cell LC_R in the third row RW3 and an upper logic cell LC_H in the fourth row RW4 may have symmetric structures to each other about the cell interface portion CBC therebetween. Although FIG. 1 illustrates the cell block 12 including six rows (for example, RW1, RW2, RW3, RW4, RW5, and RW6), this is only an example, and the cell block 12 may include rows in various numbers selected as needed or as desired, and one row may include logic cells in various numbers selected as needed or as desired.

One selected from among a plurality of ground lines VSS and a plurality of power lines VDD may be arranged between a plurality of rows (that is, RW1, RW2, RW3, RW4, RW5, and RW6), which each include the plurality of cells LC arranged in a line in the width direction (X direction in FIG. 1). The plurality of ground lines VSS and the plurality of power lines VDD may each extend in a first horizontal direction (X direction) and may be alternately arranged apart (separate) from each other in a second horizontal direction (Y direction). Therefore, each of the plurality of ground lines VSS and the plurality of power lines VDD may be arranged to overlap the cell boundary CBD of a cell LC, which extends in the second horizontal direction (Y direction).

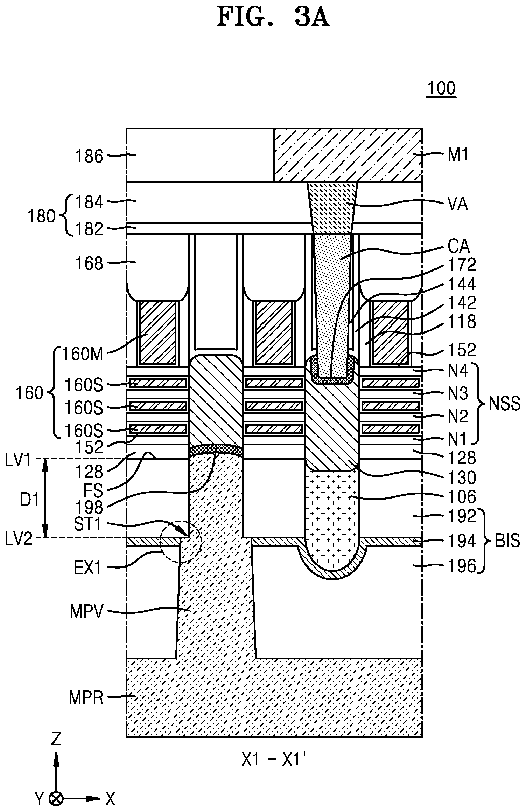

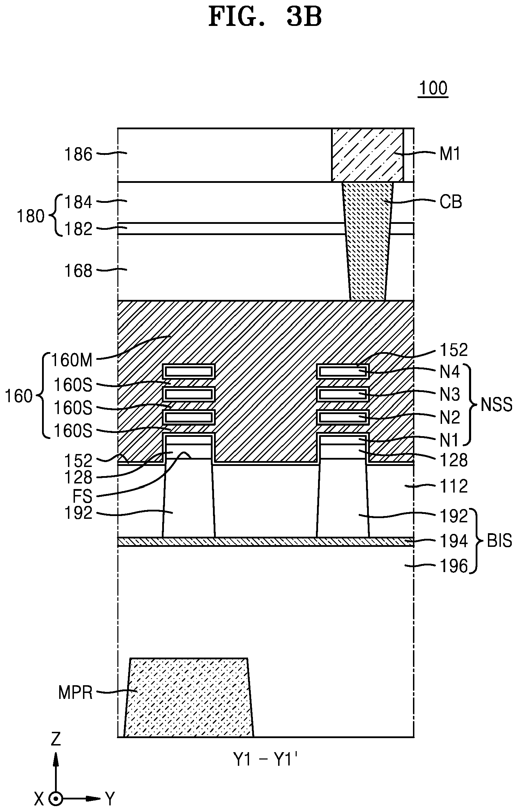

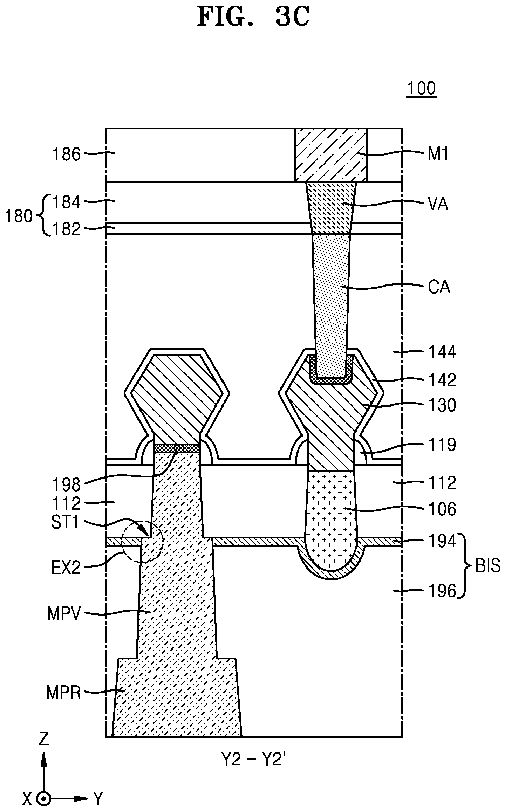

FIG. 2 is a planar layout diagram illustrating an integrated circuit device 100 according to some example embodiments. FIG. 3A is a cross-sectional view of the integrated circuit device 100, taken along a line X1-X1' of FIG. 2. FIG. 3B is a cross-sectional view of the integrated circuit device 100, taken along a line Y1-Y1' of FIG. 2. FIG. 3C is a cross-sectional view of the integrated circuit device 100, taken along a line Y2-Y2' of FIG. 2. The integrated circuit device 100 includes a field-effect transistor, which has a gate-all-around (GAA) structure including a nanowire or nanosheet-shaped active region and a gate surrounding the active region, is described with reference to FIGS. 2 and 3A to 3C. Components of the integrated circuit device 100, which are shown in FIGS. 2 and 3A to 3C, may constitute a portion of the plurality of cells LC shown in FIG. 1.

Referring to FIGS. 2 and 3A to 3C, the integrated circuit device 100 may include a backside insulating structure BIS, and a plurality of nanosheet stacks NSS, a plurality of gate lines 160, and a plurality of source/drain regions 130, which are arranged over the backside insulating structure BIS. The plurality of gate lines 160 may be apart from each other in the first horizontal direction (X direction) and each extend lengthwise in the second horizontal direction (Y direction). Each of the plurality of gate lines 160 may surround a nanosheet stack NSS, which overlaps the corresponding gate line 160 in the vertical direction (Z direction). The plurality of source/drain regions 130 may be respectively arranged one-by-one (e.g., successively, and/or neighbouring but separated each other) between the plurality of gate lines 160.

The backside insulating structure BIS may include an inner backside insulating pattern 192, an etch stop pattern 194, and an outer backside insulating pattern 196, which are sequentially stacked in the stated order from the plurality of gate lines 160 and the plurality of source/drain regions 130 toward the backside of the integrated circuit device 100. Herein, the backside of the integrated circuit device 100 refers to a position at the lowest vertical level in the vertical direction (Z direction) in the integrated circuit device 100 in FIGS. 3A to 3C. The Z direction may be perpendicular to the X direction and the Y direction, which are both horizontal with respect to a surface of the substrate.

The backside insulating structure BIS may include a frontside surface FS facing a nanosheet stack NSS and a gate line 160. The frontside surface FS of the backside insulating structure BIS may include surfaces of the inner backside insulating pattern 192, which face the gate line 160. The etch stop pattern 194 of the backside insulating structure BIS may be arranged to overlap the plurality of gate lines 160 in the vertical direction (Z direction). The inner backside insulating pattern 192 may be arranged between the etch stop pattern 194 and the plurality of gate lines 160. The inner backside insulating pattern 192 may include a different material from any constituent material of the etch stop pattern 194. As used herein, "constituent material" may refer to material, e.g. compound material, and not necessarily particular elements included in a substance.

In the backside insulating structure BIS, the outer backside insulating pattern 196 may be apart from the plurality of gate lines 160 and the inner backside insulating pattern 192 in the vertical direction (Z direction) with the etch stop pattern 194 therebetween. The outer backside insulating pattern 196 may include a different material from the constituent material of the etch stop pattern 194. In some example embodiments, each of the inner backside insulating pattern 192 and the outer backside insulating pattern 196 may include a silicon oxide film, a silicon nitride film, a silicon carbide film, a low-K film, an ultra-low-K (LTLK) film having an ultra-low dielectric constant (that is, K) of about 2.2 to about 2.4, or a combination thereof. The low-K film may include, but is not limited to, fluorine-doped silicon oxide, organosilicate glass, carbon-doped oxide, porous silicon oxide, porous organosilicate glass, a spin-on organic polymeric dielectric, a spin-on silicon-based polymeric dielectric, or a combination thereof. For example, each of the inner backside insulating pattern 192 and the outer backside insulating pattern 196 may include, but is not limited to, a tetraethylorthosilicate (TEOS) film, a high density plasma (HDP) oxide film, a boro-phospho-silicate glass (BPSG) film, a flowable chemical vapor deposition (FCVD) oxide film, a SiON film, a SiN film, a SiOC film, a SiCOH film, or a combination thereof. The etch stop pattern 194 may include an aluminum oxide film, a titanium oxide film, a silicon nitride film, or a combination thereof.

A plurality of device isolation films 112 may be respectively arranged in some regions between the etch stop pattern 194 and the plurality of gate lines 160. The plurality of device isolation films 112 may be apart from each other in the second horizontal direction (Y direction) with a portion of the inner backside insulating pattern 192 therebetween and may be arranged in a line in the second horizontal direction (Y direction). Each of the plurality of device isolation films 112 may be apart from the outer backside insulating pattern 196 in the vertical direction (Z direction) with the etch stop pattern 194 therebetween. Each of the plurality of device isolation films 112 may include, but is not limited to, a silicon oxide film.

The etch stop pattern 194 may have a liner shape covering, e.g., conformally covering a surface of each of the plurality of device isolation films 112 and the inner backside insulating pattern 192. In the backside insulating structure BIS, the thickness of the etch stop pattern 194 in the vertical direction (Z direction) may be less than the thickness of each of the inner backside insulating pattern 192 and the outer backside insulating pattern 196 in the vertical direction (Z direction).

In the backside insulating structure BIS, the inner backside insulating pattern 192, the etch stop pattern 194, and the outer backside insulating pattern 196 may be arranged in the stated order over a lower surface of the gate line 160 to fully or at least partially overlap each other in the vertical direction (Z direction).

Each of the plurality of nanosheet stacks NSS may include at least one nanosheet, which is arranged apart from the frontside surface FS of the backside insulating structure BIS in the vertical direction (Z direction) to face the frontside surface FS of the backside insulating structure BIS. As used herein, the term "nanosheet" refers to a conductive structure having a cross-section that is substantially perpendicular to a current-flowing direction. The nanosheet may also be understood as including a nanowire.

Each of the plurality of nanosheet stacks NSS may include a number of nanosheets such as a first nanosheet N1, a second nanosheet N2, a third nanosheet N3, and a fourth nanosheet N4, which overlap each other in the vertical direction (Z direction), over the frontside surface FS of the backside insulating structure BIS. The first to fourth nanosheets N1, N2, N3, and N4 may respectively have different vertical distances (Z-direction distances) from the frontside surface FS of the backside insulating structure BIS. Each of the first to fourth nanosheets N1, N2, N3, and N4, which are included in the nanosheet stack NSS, may function as a channel region. Herein, a nanosheet may be referred to as a channel region. In some example embodiments, each of the first to fourth nanosheets N1, N2, N3, and N4 of the nanosheet stack NSS may include a Si layer, a SiGe layer, or a combination thereof. Each of the first to fourth nanosheets N1, N2, N3, and N4 may include the same material, or at least one of the first to fourth nanosheets N1, N2, N3, and N4 may include a material not included in others of the first to fourth nanosheets N1, N2, N3, and N4; example embodiments are not limited thereto.

Although examples illustrate that each of the plurality of nanosheet stacks NSS includes four nanosheets, for example, the first to fourth nanosheets N1, N2, N3, and N4, embodiments of the inventive concept are not limited thereto. For example, each of the plurality of nanosheet stacks NSS may include at least two nanosheets such as two or more nanosheets, and the number of nanosheets constituting the nanosheet stack NSS is not particularly limited. The number of and/or the thicknesses of the plurality of nanosheets included in the plurality of nanosheet stacks NSS may be the same, or different from, each other.

Each of the first to fourth nanosheets N1, N2, N3, and N4 may have a channel region. In each of the second to fourth nanosheets N2, N3, and N4 except for the first nanosheet N1 from among the first to fourth nanosheets N1, N2, N3, and N4, a channel may be formed in the vicinity of upper and lower surfaces of each of the second to fourth nanosheets N2, N3, and N4. Although a channel may be formed in the vicinity of the upper surface of the first nanosheet N1, no channel is formed in the lower surface of the first nanosheet N1, which faces the inner backside insulating pattern 192.

In some example embodiments, each of the first to fourth nanosheets N1, N2, N3, and N4 may have a vertical-direction thickness selected from a range of about 4 nm to about 6 nm. In some example embodiments, the first to fourth nanosheets N1, N2, N3, and N4 may have substantially the same thickness. The first to fourth nanosheets N1, N2, N3, and N4 may include the same material (e.g., exactly the same material).

As shown in FIGS. 3A and 3B, each of the plurality of gate lines 160 may be arranged over the inner backside insulating pattern 192 to cover the plurality of nanosheet stacks NSS and surround at least portions of the first to fourth nanosheets N1, N2, N3, and N4. Each of the plurality of gate lines 160 may include a main gate portion 160M, which covers the upper surface of the nanosheet stack NSS and extends in the second horizontal direction (Y direction), and a plurality of sub-gate portions 160S, which are integrally connected to the main gate portion 160M and respectively arranged in separation spaces between the first to fourth nanosheets N1, N2, N3, and N4. In the vertical direction (Z direction), the thickness of each of the plurality of sub-gate portions 160S may be less than the thickness of the main gate portion 160M. Each of the plurality of gate lines 160 does not extend to a space between the inner backside insulating pattern 192 and the first nanosheet N1, and thus, each of the plurality of gate lines 160 does not include a sub-gate portion between the inner backside insulating pattern 192 and the first nanosheet N1. Therefore, as shown in FIGS. 3A and 3B, the second to fourth nanosheets N2, N3, and N4 except for the first nanosheet N1 from among the first to fourth nanosheets N1, N2, N3, and N4 may each have a GAA structure in which each of the second to fourth nanosheets N2, N3, and N4 is completely surrounded by a gate line 160. On the other hand, the first nanosheet N1 may not have a GAA structure. In more detail, the lower surface of the first nanosheet N1, which faces the inner backside insulating pattern 192, may not be covered by the gate line 160 and only the upper surface of the first nanosheet N1 facing the second nanosheet N2 and both sidewalls of the first nanosheet N1 in the second horizontal direction (Y direction) may be covered by the gate line 160. Therefore, although a portion of the first nanosheet N1 in the vicinity of the upper surface thereof facing the second nanosheet N2 and portions of the first nanosheet N1 in the vicinity of both sidewalls thereof in the second horizontal direction (Y direction) may be used as a channel region, a portion of the first nanosheet N1 in the vicinity of the lower surface thereof facing the inner backside insulating pattern 192 is not allowed to be used as or may not act as a channel region.

The space between the first nanosheet N1 and the inner backside insulating pattern 192 may be filled with a bottom insulating structure 128. Therefore, the first nanosheet N1 may constitute a fully depleted device.

The bottom insulating structure 128 may include silicon oxide, SiOC, SiOCN, SiCN, SiBN, SiON, SiBCN, SiOF, SiOCH, or a combination thereof. The bottom insulating structure 128 may include a single film including one material film selected from the materials listed above or may include a multi-film including a plurality of material films selected from the materials listed above. As used herein, each of the terms "SiOC", "SiOCN", "SiCN", "SiBN", "SiON", "SiBCN", "SiOF", and "SiOCH" refers to a material including elements contained in each term and is not a chemical formula representing a stoichiometric relationship.

Each of the plurality of source/drain regions 130 may be arranged adjacent to at least one gate line 160 selected from the plurality of gate lines 160. Each of the plurality of source/drain regions 130 may have surfaces contacting the first to fourth nanosheets N1, N2, N3, and N4, which are included in the nanosheet stack NSS adjacent thereto.

Each of the plurality of source/drain regions 130 may include an epitaxial layer, e.g., an epitaxially grown semiconductor layer. In some example embodiments, each of the plurality of source/drain regions 130 may include an epitaxially grown Si layer, an epitaxially grown SiC layer, or a plurality of epitaxially grown SiGe layers. There may be an interface between the source/drain regions 130 and other layers such as a placeholder 106 (to be described below); example embodiments are not limited thereto. When a source/drain region 130 constitutes an NMOS transistor, the source/drain region 130 may include a Si layer doped with an n-type dopant or a SiC layer doped with an n-type dopant. The n-type dopant may be selected from phosphorus (P), arsenic (As), and antimony (Sb). When the source/drain region 130 constitutes a PMOS transistor, the source/drain region 130 may include a SiGe layer doped with a p-type dopant. The p-type dopant may be selected from boron (B) and gallium (Ga). In some example embodiments, when the source/drain region 130 constitutes an NMOS transistor, the source/drain region 130 may include p-type dopants at a much lower concentration than those of n-type dopants; alternatively or additionally, when the source/drain region 130 constitutes a PMOS transistor, the source/drain region 130 may include n-type dopants at a much lower concentration than those of p-type dopants; example embodiments are not limited thereto.

Each of the plurality of gate lines 160 may include a metal, a metal nitride, a metal carbide, or a combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may include TiAlC. However, a material constituting each of the plurality of gate lines 160 is not limited to the examples set forth above.

A gate dielectric film 152 may be arranged between the nanosheet stack NSS and the gate line 160. The gate dielectric film 152 may include a stack structure of an interface dielectric film and a high-K film. The interface dielectric film may include a low-K material film having a dielectric constant of 9 or less, for example, a silicon oxide film, a silicon oxynitride film, or a combination thereof. In some example embodiments, the interface dielectric film may be omitted. The high-K film may include a material having a dielectric constant that is greater than that of a silicon oxide film. For example, the high-K film may have a dielectric constant of about 10 to about 25. The high-K film may include, but is not limited to, hafnium oxide.

One or two, e.g., either sidewall, of each of the plurality of sub-gate portions 160S, which are included in each of the plurality of gate lines 160, may be apart from the source/drain region 130 with the gate dielectric film 152 therebetween. The gate dielectric film 152 may be arranged between a sub-gate portion 160S of the gate line 160 and each of the first to fourth nanosheets N1, N2, N3, and N4 and between the sub-gate portion 160S of the gate line 160 and the source/drain region 130. The gate dielectric film 152 may include portions contacting the bottom insulating structure 128.

The plurality of gate lines 160, the plurality of nanosheet stacks NSS, and the plurality of source/drain regions 130 may respectively constitute a plurality of nanosheet transistors. Each of the plurality of nanosheet transistors may include an NMOS transistor, a PMOS transistor, or a combination thereof.

As shown in FIG. 3A, both sidewalls of the gate line 160 may be respectively covered by a plurality of main insulating spacers 118. Each of the plurality of main insulating spacers 118 may be arranged on the upper surface of the nanosheet stack NSS to cover a sidewall of the main gate portion 160M. Each of the plurality of main insulating spacers 118 may be apart from the gate line 160 with the gate dielectric film 152 therebetween.

As shown in FIG. 3C, a plurality of side insulating spacers 119 may be arranged on the device isolation film 112. At least a portion of each of the plurality of side insulating spacers 119 may cover a sidewall of the source/drain region 130. In some example embodiments, each of the plurality of side insulating spacers 119 may be integrally connected with a main insulating spacer 118 adjacent thereto.

Each of the plurality of main insulating spacers 118 and the plurality of side insulating spacers 119 may include silicon nitride, silicon oxide, SiOC, SiOCN, SiCN, SiBN, SiON, SiBCN, SiOF, SiOCH, or a combination thereof. Each of the plurality of main insulating spacers 118 and the plurality of side insulating spacers 119 may include a single film including one material film selected from the materials listed above or may include a multi-film including a plurality of material films selected from the materials listed above.

As shown in FIGS. 3A and 3B, the upper surface of each of the gate line 160, the gate dielectric film 152, and the main insulating spacer 118 may be covered by a capping insulating pattern 168. Each capping insulating pattern 168 may include a silicon nitride film.

The plurality of source/drain regions 130, the device isolation film 112, the plurality of main insulating spacers 118, and the plurality of side insulating spacers 119 may be covered by an insulating liner 142. An inter-gate dielectric 144 may be arranged on the insulating liner 142. The inter-gate dielectric 144 may be arranged between a pair of gate lines 160, which are adjacent to each other in the first horizontal direction (X direction), and between a pair of source/drain regions 130 adjacent to each other. In some example embodiments, the insulating liner 142 may include, but is not limited to, silicon nitride, SiCN, SiBN, SiON, SiOCN, SiBCN, or a combination thereof. The inter-gate dielectric 144 may include, but is not limited to, a silicon oxide film.

As shown in FIGS. 3A and 3C, a plurality of source/drain contacts CA may be arranged respectively on the plurality of source/drain regions 130 between a pair of gate lines 160 adjacent to each other from among the plurality of gate lines 160. Each of the plurality of source/drain contacts CA may be configured to be electrically connected to at least one source/drain region 130 selected from the plurality of source/drain regions 130. For example, as shown in FIG. 2, one source/drain contact CA may be connected to two adjacent source/drain regions 130, or as shown in FIGS. 2 and 3C, one source/drain contact CA may be connected to one source/drain region 130, but embodiments of the inventive concept are not limited thereto. The source/drain contact CA may be apart from the main gate portion 160M of the gate line 160, which is adjacent thereto, in the first horizontal direction (X direction) with the main insulating spacer 118 therebetween.

A metal silicide film 172 may be arranged between the source/drain region 130 and the source/drain contact CA. The metal silicide film 172 may be in contact with the source/drain region 130. The source/drain contact CA may pass through the inter-gate dielectric 144 and the insulating liner 142 in the vertical direction (Z direction) to be in contact with the metal silicide film 172. The source/drain contact CA may be configured to be connected to the source/drain region 130 via the metal silicide film 172. The source/drain contact CA may pass through a portion of the source/drain region 130 in the vertical direction (Z direction). The insulating liner 142 and the inter-gate dielectric 144 may surround a sidewall of the source/drain contact CA.

In some example embodiments, the metal silicide film 172 may include one or more of Ti, W, Ru, Nb, Mo, Hf, Ni, Co, Pt, Yb, Tb, Dy, Er, or Pd. For example, the metal silicide film 172 may include titanium silicide. In some example embodiments, the source/drain contact CA may include only a metal plug including a single metal. In some example embodiments, the source/drain contact CA may include a metal plug and a conductive barrier film surrounding the metal plug. The metal plug may include, but is not limited to, molybdenum (Mo), tungsten (W), cobalt (Co), ruthenium (Ru), manganese (Mn), titanium (Ti), tantalum (Ta), aluminum (Al), copper (Cu), a combination thereof, or an alloy thereof. The conductive barrier film may include a metal or a conductive metal nitride. For example, the conductive barrier film may include, but is not limited to, Ti, Ta, W, TiN, TaN, WN, WCN, TiSiN, TaSiN, WSiN, or a combination thereof.

Respective upper surfaces of the source/drain contact CA, a plurality of capping insulating patterns 168, and the inter-gate insulating film 144 may be covered by an upper insulating structure 180. The upper insulating structure 180 may include a frontside etch stop film 182 and an upper insulating film 184, which are sequentially stacked in the stated order on each of the plurality of source/drain contacts CA, the plurality of capping insulating patterns 168, and the inter-gate insulating film 144. The frontside etch stop film 182 may include silicon carbide (SiC), SiN, SiCN, SiOC, AlN, AlON, AlO, AlOC, or a combination thereof. The upper insulating film 184 may include an oxide film, a nitride film, a LTLK film having an ultra-low dielectric constant (that is, K) of about 2.2 to about 2.4, or a combination thereof. For example, the upper insulating film 184 may include, but is not limited to, a TEOS film, an HDP oxide film, a BPSG film, an FCVD oxide film, a SiON film, a SiN film, a SiOC film, a SiCOH film, or a combination thereof.

A source/drain via contact VA may be arranged on the source/drain contact CA. A plurality of source/drain via contacts VA may each pass through the upper insulating structure 180 to contact the source/drain contact CA. The source/drain region 130 connected to the source/drain contact CA, from among the plurality of source/drain regions 130, may be configured to be electrically connected to the source/drain via contact VA via the metal silicide film 172 and the source/drain contact CA. Each of the plurality of source/drain via contacts VA may include, but is not limited to, molybdenum (Mo) and/or tungsten (W).

As shown in FIG. 3B, a gate contact CB may be arranged on the gate line 160. The gate contact CB may be configured to pass through the upper insulating structure 180 and the capping insulating pattern 168 in the vertical direction (Z direction) to be connected to the gate line 160. A lower surface of the gate contact CB may be in contact with the upper surface of the gate line 160. The gate contact CB may include a contact plug including molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but a constituent material of the contact plug is not limited to the examples set forth above. In some example embodiments, the gate contact CB may further include a conductive barrier pattern surrounding a portion of the contact plug. The conductive barrier pattern of the gate contact CB may include a metal and/or a metal nitride. For example, the conductive barrier pattern may include, but is not limited to, Ti, Ta, W, TiN, TaN, WN, WCN, TiSiN, TaSiN, WSiN, or a combination thereof.

An upper surface of the upper insulating structure 180 may be covered by a frontside interlayer dielectric 186. A constituent material of the frontside interlayer dielectric 186 is substantially the same as the constituent material of the upper insulating film 184 described above. A plurality of upper wiring layers M1 may be arranged through the frontside interlayer dielectric 186. Each of the plurality of upper wiring layers M1 may be connected to the source/drain via contact VA or the gate contact CB. Each of the plurality of upper wiring layers M1 may include, but is not limited to, molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof.

As shown in FIGS. 3A and 3C, some source/drain regions 130 selected from the plurality of source/drain regions 130 may each be configured to be connected to a backside via contact MPV passing through the backside insulating structure BIS in the vertical direction (Z direction). The backside insulating structure BIS may surround a sidewall of the backside via contact MPV.

As shown in a region EX1 of FIG. 3A and a region EX2 of FIG. 3C, the backside via contact MPV may include a stepped portion ST1. The stepped portion ST1 of the backside via contact MPV may be apart from a first vertical level LV1 in the vertical direction (Z direction) by as much as a first distance D1, the first vertical level LV1 being closest to the plurality of gate lines 160 in (or with regard to) the backside insulating structure BIS. The stepped portion ST1 of the backside via contact MPV may include a portion of the backside via contact MPV, which has a change in the width of the backside via contact MPV in a horizontal direction (for example, the X direction and/or the Y direction) at a second vertical level LV2 that is adjacent to or at substantially (eg exactly) the same vertical level as the etch stop pattern 194 pierced by the backside via contact MPV. The stepped portion ST1 may have a sharp corner step, e.g., a step forming an angle of 90 degrees; however, example embodiments are not limited thereto.

As shown in FIGS. 3A and 3C, the backside via contact MPV may include a first contact portion passing through the inner backside insulating pattern 192, a second contact portion passing through the etch stop pattern 194, and a third contact portion passing through the outer backside insulating pattern 196. The first contact portion, the second contact portion, and the third contact portion may be integrally connected to each other. In the backside via contact MPV, a sidewall of the first contact portion may be in contact with the inner backside insulating pattern 192, a sidewall of the second contact portion may be in contact with the etch stop pattern 194, and a sidewall of the third contact portion may be in contact with the outer backside insulating pattern 196. In the backside via contact MPV, the sidewall of each of the first contact portion and the third contact portion may not be in contact with the etch stop pattern 194. A horizontal-direction width of the first contact portion of the backside via contact MPV, which passes through the inner backside insulating pattern 192, may be less than a horizontal-direction width of each of the second and third contact portions of the backside via contact MPV, which respectively pass through the etch stop pattern 194 and the outer backside insulating pattern 196. The etch stop pattern 194 may include a portion extending flat in the horizontal direction (for example, the X direction and/or the Y direction) around the stepped portion ST1 of the backside via contact MPV.

In the backside via contact MPV, the stepped portion ST1 may have a ring shape surrounding the perimeter of the backside via contact MPV at the second vertical level LV2 that is adjacent to the etch stop pattern 194. In the backside via contact MPV, a vertical central axis of the first contact portion, which passes through the inner backside insulating pattern 192, and a vertical central axis of each of the second and third contact portions, which respectively pass through the etch stop pattern 194 and the outer backside insulating pattern 196, may be aligned with each other to extend along a straight line in the vertical direction (Z direction).

A metal silicide film 198 may be arranged between the backside via contact MPV and the source/drain region 130. The metal silicide film 198 may be in contact with the source/drain region 130. The backside via contact MPV may be in contact with the metal silicide film 198. The backside via contact MPV may be configured to be connected to the source/drain region 130 via the metal silicide film 198.

In some example embodiments, an end portion of the backside via contact MPV, which is farthest from the source/drain region 130 in the vertical direction (Z direction), may be connected to a backside power rail MPR. The backside power rail MPR may have a line shape linearly extending lengthwise in a direction such as the first horizontal direction (X direction). The backside insulating structure BIS may surround a sidewall of the backside power rail MPR. In some example embodiments, the backside via contact MPV and the backside power rail MPR may be simultaneously formed in a single process such as a single damascene process, and here, the backside via contact MPV and the backside power rail MPR may be integrally connected to each other and include the same material. Alternatively in some example embodiments, the backside via contact MPV and the backside power rail MPR may be respectively formed in separate processes such as separate damascene processes, and here, there may be an interface between the backside via contact MPV and the backside power rail MPR. The interface may be observable, for example, with a scanning-electron microscope (SEM) and/or a transmission electron microscope (TEM) cross-section; example embodiments are not limited thereto. Respective constituent materials of the backside via contact MPV and the metal silicide film 198 are the same as those of the source/drain contact CA and the metal silicide film 172 described above.

Some other source/drain regions 130 selected from the plurality of source/drain regions 130 may each be covered by a place holder 106. The place holder 106 may be arranged to overlap, in the vertical direction (Z direction), another source/drain region 130 that is apart from a source/drain region 130, which is connected to the backside via contact MPV from among the plurality of source/drain regions 130, in the horizontal direction (for example, the X direction). Generally, any reference to a place holder herein may additionally or alternatively be considered to refer to a spacer.

As shown in FIG. 3A, the lower surface of the source/drain region 130 connected to the source/drain contact CA, from among the plurality of source/drain regions 130, may be in contact with the place holder 106. The place holder 106 may include an upper surface contacting the source/drain region 130, a sidewall facing the backside via contact MPV with a portion of the backside insulating structure BIS therebetween in the horizontal direction (for example, the X direction), a sidewall facing the device isolation film 112 in the horizontal direction (for example, the Y direction), and a lower surface that is opposite to the upper surface of the place holder 106 in the vertical direction (Z direction). The sidewall and the lower surface of the place holder 106 may be in contact with the backside insulating structure BIS. In more detail, the sidewall of the place holder 106 may be in contact with the inner backside insulating pattern 192 and the lower surface of the place holder 106 may be in contact with the etch stop pattern 194. Herein, the upper surface of the place holder 106 may be referred to as a holder upper surface, the sidewall of the place holder 106 may be referred to as a holder sidewall, and the lower surface of the place holder 106 may be referred to as a holder lower surface.

The etch stop pattern 194 of the backside insulating structure BIS may include a portion contacting the inner backside insulating pattern 192 and a portion contacting the lower surface of the place holder 106. Herein, the portion of the etch stop pattern 194, which is in contact with the inner backside insulating pattern 192, may be referred to as a first liner portion, and the portion of the etch stop pattern 194, which is in contact with the lower surface of the place holder 106, may be referred to as a second liner portion. As shown in FIGS. 3A and 3C, the second liner portion of the etch stop pattern 194, which is in contact with the lower surface of the place holder 106, may have a cross-sectional shape that is concave toward the place holder 106.

The place holder 106 may be apart from the backside via contact MPV in the horizontal direction (for example, the X direction and/or the Y direction) and arranged at a vertical level that is equal or similar to that of a portion of the backside via contact MPV. As used herein in relation to embodiment, the term "vertical level" refers to a distance in the vertical direction (Z direction or -Z direction) from the first vertical level LV1, which is closest to the plurality of gate lines 160 in the backside insulating structure BIS. More generally, a "level" may be considered as a plane. Thus, a "vertical level" generally comprises a plane substantially perpendicular to the vertical direction, eg an exactly horizontal and/or at a substantially constant height or distance relative to a reference level such as a plane comprising the backside.

The place holder 106 may include a material that is different from, e.g., from any of, the constituent material of each of the inner backside insulating pattern 192, the etch stop pattern 194, and the outer backside insulating pattern 196. In some example embodiments, the place holder 106 may include, but is not limited to, a doped SiGe film, an undoped SiGe film, an aluminum oxide film, a titanium oxide film, a silicon nitride film, or a combination thereof.

As shown in FIG. 3C, the device isolation film 112 may include a portion between the backside via contact MPV and the place holder 106. An upper surface of the device isolation film 112 may be in contact with the gate dielectric film 152, and a lower surface of the device isolation film 112 may be in contact with the etch stop pattern 194. The device isolation film 112 may include portions contacting the inner backside insulating pattern 192, portions contacting the backside via contact MPV, and portions contacting the place holder 106.

As described with reference to FIGS. 2 and 3A to 3C, in the integrated circuit device 100, some source/drain regions 130 from among the plurality of source/drain regions 130 may each be configured to be connected to the backside via contact MPV, and some other source/drain regions 130 may each be configured to be connected to the source/drain contact CA. Therefore, in the integrated circuit device 100, a sufficient insulating distance may be secured between a plurality of backside via contacts MPV and between the plurality of source/drain contacts CA, thereby in embodiments preventing or reducing the likelihood of and/or the impact from parasitic capacitance. Therefore, according to the integrated circuit device 100 example embodiments, even when the integrated circuit device 100 includes a plurality of wiring structures arranged in an area reduced due to down-scaling, a sufficient insulating distance may be secured or may be more likely to be secured between conductive regions, thereby in embodiments desirably preventing or reducing the likelihood of an unintended short-circuit between a plurality of conductive regions and/or of improving the reliability of the integrated circuit device 100.

Alternatively or additionally, the integrated circuit device 100 according to example embodiments includes the backside via contact MPV as a backside wiring structure for supplying power and/or signals to the source/drain region 130 from the backside of the integrated circuit device 100, and the backside insulating structure BIS surrounding the backside via contact MPV includes the etch stop pattern 194. The backside via contact MPV may be configured to pass through the etch stop pattern 194 in the vertical direction (Z direction) so as to be connected to the plurality of source/drain regions 130. During a fabrication process of the integrated circuit device 100, to form the backside via contact MPV, when a via hole is formed through a portion of the backside insulating structure BIS in the vertical direction (Z direction) from the backside of the backside insulating structure BIS, even though a strict design rule may not be used to align the position of the via hole to an intended target position, because the backside insulating structure BIS includes the etch stop pattern 194, the etch stop pattern 194 may prevent or reduce the likelihood that the via hole unintentionally reaches up to another conductive line, for example, the gate line 160, the source/drain region 130, or a region adjacent thereto, on the frontside of the integrated circuit device 100. Therefore, the integrated circuit device 100 according to example embodiments may provide more a stable and/or improved or optimized wiring structure even in an area reduced due to down-scaling, and thus, the degree of integration and the reliability of the integrated circuit device 100 may improve.

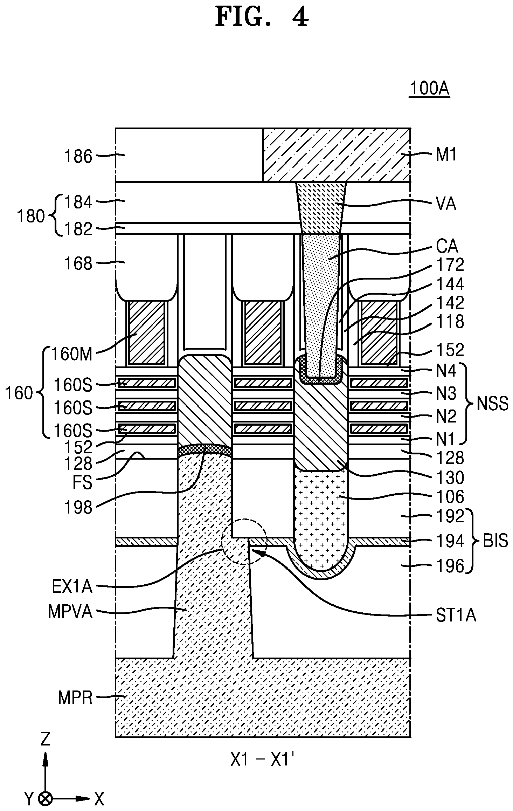

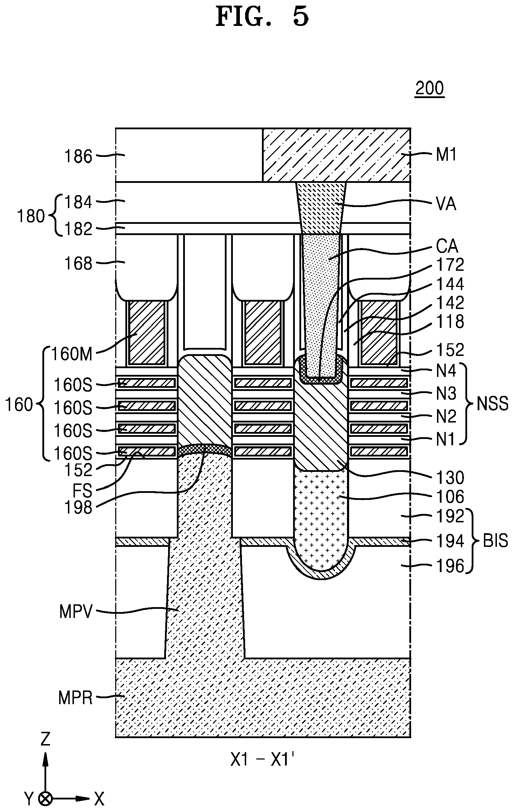

FIGS. 4 and 5 are cross-sectional views respectively illustrating integrated circuit devices 100A and 200 according to some example embodiments. FIGS. 4 and 5 respectively illustrate cross-sectional configurations of portions of the integrated circuit devices 100A and 200, which correspond to the cross-section taken along the line X1-X1' of FIG. 2. In FIGS. 4 and 5, the same reference numerals as in FIGS. 2 and 3A to 3C respectively denote the same members, and here, repeated descriptions thereof are omitted. Components shown in FIG. 4 or 5 may constitute a portion of the plurality of cells LC shown in FIG. 1.

Referring to FIG. 4, the integrated circuit device 100A may have substantially the same configuration as the integrated circuit device 100 described with reference to FIGS. 2 and 3A to 3C. However, the integrated circuit device 100A includes a backside via contact MPVA passing through the backside insulating structure BIS.

The backside via contact MPVA may have substantially the same configuration as the backside via contact MPV described with reference to FIGS. 2, 3A, and 3C. However, as shown in a region EX1A of FIG. 4, the backside via contact MPVA may include a stepped portion ST1A. The stepped portion ST1A of the backside via contact MPVA may be formed to be biased toward one side in the horizontal direction from a central axis of the backside via contact MPVA, the central axis extending in the length direction (for example, the Z direction in FIG. 4) of the backside via contact MPVA. For example, the stepped portion ST1A of the backside via contact MPVA may be formed in only a portion of the perimeter of the backside via contact MPVA.

The stepped portion ST1A of the backside via contact MPVA may be arranged apart from the plurality of gate lines 160 in the vertical direction (Z direction) and may include a portion of the backside via contact MPVA, which has a change in the width of the backside via contact MPVA in the horizontal direction (for example, the X direction), at a vertical level adjacent to the etch stop pattern 194 pierced by the backside via contact MPVA.

The backside via contact MPVA may include a first contact portion passing through the inner backside insulating pattern 192, a second contact portion passing through the etch stop pattern 194, and a third contact portion passing through the outer backside insulating pattern 196. The first contact portion, the second contact portion, and the third contact portion may be integrally connected to each other. A horizontal-direction width of the first contact portion of the backside via contact MPVA, which passes through the inner backside insulating pattern 192, may be less than a horizontal-direction width of each of the second and third contact portions of the backside via contact MPVA, which respectively pass through the etch stop pattern 194 and the outer backside insulating pattern 196. In the backside via contact MPVA, a vertical central axis of the first contact portion, which passes through the inner backside insulating pattern 192, may be misaligned, in the horizontal direction, with a vertical central axis of each of the second and third contact portions, which respectively pass through the etch stop pattern 194 and the outer backside insulating pattern 196.

The metal silicide film 198 may be arranged between the backside via contact MPVA and the source/drain region 130. The backside via contact MPVA may be configured to be connected to the source/drain region 130 via the metal silicide film 198. An end portion of the backside via contact MPVA, which is farthest from the source/drain region 130, may be connected to the backside power rail MPR.

Referring to FIG. 5, the integrated circuit device 200 may have substantially the same configuration as the integrated circuit device 100 described with reference to FIGS. 2 and 3A to 3C. However, the integrated circuit device 200 does not include the bottom insulating structure 128 shown in FIGS. 3A and 3B.

In the integrated circuit device 200, each of the plurality of gate lines 160 may be arranged over the inner backside insulating pattern 192 to cover the plurality of nanosheet stacks NSS and may include four sub-gate portions 160S surrounding at least portions of the first to fourth nanosheets N1, N2, N3, and N4. The gate dielectric film 152 may be arranged between the inner backside insulating pattern 192 and the sub-gate portion 160S that is closest to the backside insulating pattern 192 from among the four sub-gate portions 160S, and the frontside surface FS of the backside insulating structure BIS may be in contact with the gate dielectric film 152.

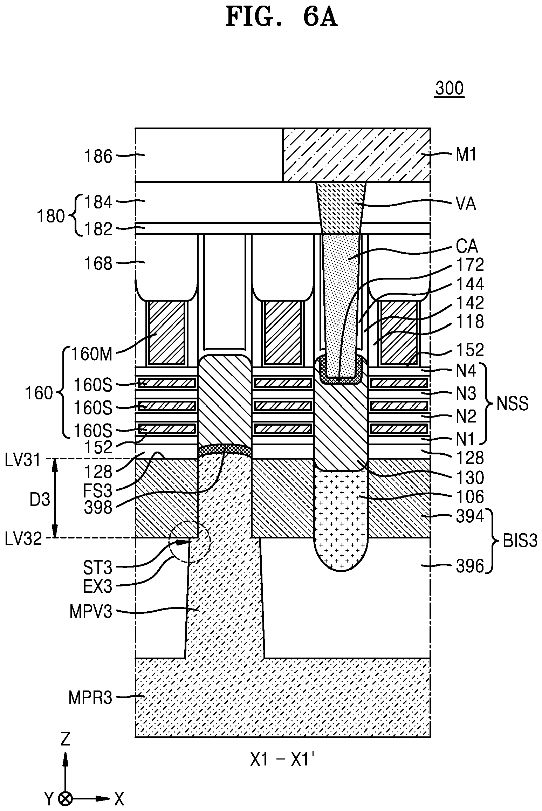

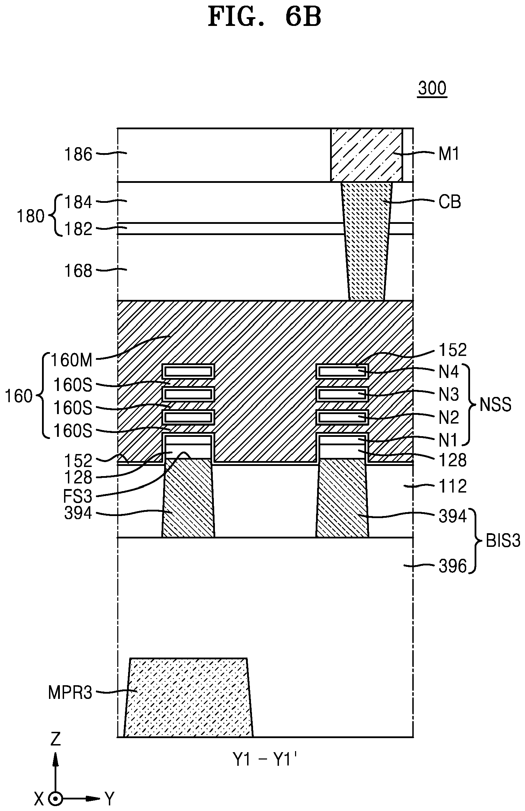

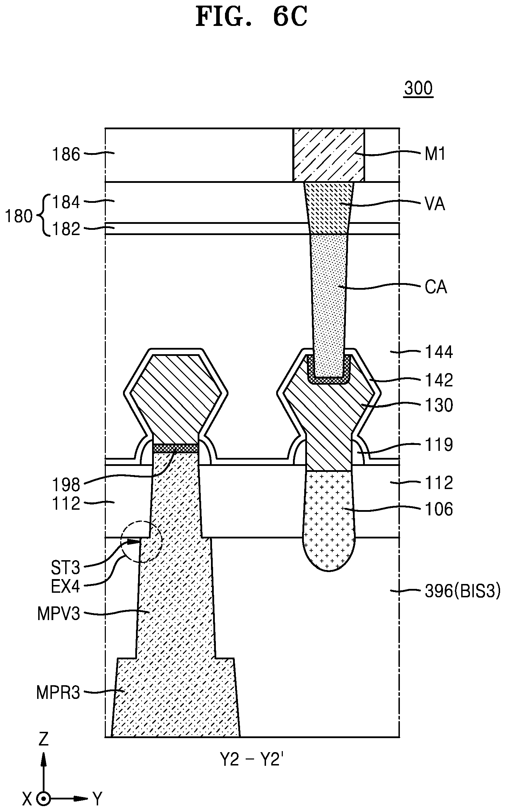

FIGS. 6A to 6C are cross-sectional views illustrating an integrated circuit device 300 according to some example embodiments, and in particular, FIG. 6A is a cross-sectional view of a portion of the integrated circuit device 300, which corresponds to the cross-section taken along the line X1-X1' of FIG. 2, FIG. 6B is a cross-sectional view of a portion of the integrated circuit device 300, which corresponds to the cross-section taken along the line Y1-Y1' of FIG. 2, and FIG. 6C is a cross-sectional view of a portion of the integrated circuit device 300, which corresponds to the cross-section taken along the line Y2-Y2' of FIG. 2. Components shown in FIGS. 6A to 6C may constitute a portion of the plurality of cells LC shown in FIG. 1. In FIGS. 6A to 6C, the same reference numerals as in FIGS. 2 and 3A to 3C respectively denote the same members, and here, repeated descriptions thereof are omitted.

Referring to FIGS. 6A to 6C, the integrated circuit device 300 may have substantially the same configuration as the integrated circuit device 100 described with reference to FIGS. 2 and 3A to 3C. However, the integrated circuit device 300 includes a backside insulating structure BIS3 and a backside via contact MPV3 passing through the backside insulating structure BIS3.

The plurality of nanosheet stacks NSS, the plurality of gate lines 160, and the plurality of source/drain regions 130 may be arranged over the backside insulating structure BIS3. The backside insulating structure BIS3 may include an etch stop pattern 394 and an outer backside insulating pattern 396, which are sequentially arranged in the stated order from the plurality of gate lines 160 and the plurality of source/drain regions 130 toward the backside of the integrated circuit device 300. The etch stop pattern 394 and the outer backside insulating pattern 396 may each be arranged in the stated order over the lower surface of the gate line 160 to overlap the gate line 160 in the vertical direction (Z direction).

The backside insulating structure BIS3 may include a frontside surface FS3 facing the nanosheet stack NSS and the gate line 160. The frontside surface FS3 of the backside insulating structure BIS3 may include surfaces of the etch stop pattern 394, which face the gate line 160. The etch stop pattern 394 may be in contact with the bottom insulating structure 128.

The etch stop pattern 394 of the bottom insulating structure 128 may be arranged to overlap the plurality of gate lines 160 in the vertical direction (Z direction). The etch stop pattern 394 may include a gap-fill pattern that fills a gap between the backside via contact MPV3 and the place holder 106.

In the backside insulating structure BIS3, the outer backside insulating pattern 396 may be apart from the plurality of gate lines 160 in the vertical direction (Z direction) with the etch stop pattern 394 therebetween. The etch stop pattern 394 and the outer backside insulating pattern 396 may include different materials from each other, e.g., may not include a common material. Specific examples of respective constituent materials of the etch stop pattern 394 and the outer backside insulating pattern 396 are substantially the same as those of the etch stop pattern 194 and the outer backside insulating pattern 196, which are described with reference to FIGS. 3A to 3C.

In the integrated circuit device 300, the sidewall of the place holder 106 may be in contact with the etch stop pattern 394 and the lower surface of the place holder 106 may be in contact with the outer backside insulating pattern 396. As shown in FIG. 6A, the etch stop pattern 394 may be in contact with the sidewall of the place holder 106 and may not be in contact with the lower surface of the place holder 106. As shown in FIGS. 6A and 6C, the outer backside insulating pattern 396 may include a flat surface, which is in contact with the etch stop pattern 394, and a surface, which is in contact with the lower surface of the place holder 106 and concave toward the place holder 106.

As shown in FIG. 6B, a plurality of device isolation films 112 may be respectively arranged in some regions between the outer backside insulating pattern 396 and the plurality of gate lines 160. The plurality of device isolation films 112 may be apart from each other in the second horizontal direction (Y direction) with a portion of the etch stop pattern 394 therebetween and may be arranged in a line in the second horizontal direction (Y direction). Each of the plurality of device isolation films 112 may be in contact with the outer backside insulating pattern 396.

As shown in FIGS. 6A and 6C, some source/drain regions 130 selected from the plurality of source/drain regions 130 may each be configured to be connected to the backside via contact MPV3 passing through the backside insulating structure BIS3 in the vertical direction (Z direction). The backside insulating structure BIS3 may surround a sidewall of the backside via contact MPV3.

As shown in a region EX3 of FIG. 6A and a region EX4 of FIG. 6C, the backside via contact MPV3 may include a stepped portion ST3. The stepped portion ST3 of the backside via contact MPV3 may be apart from a first vertical level LV31 in the vertical direction (Z direction) by as much as a first distance D3, the first vertical level LV31 being closest to the plurality of gate lines 160 in the backside insulating structure BIS3. The stepped portion ST3 of the backside via contact MPV3 may include a portion having a change in the width of the backside via contact MPV3 in the horizontal direction (for example, the X direction and/or the Y direction) at a second vertical level LV32 that is adjacent to the etch stop pattern 394 pierced by the backside via contact MPV3. In the present example, the second vertical level LV32 may correspond to a vertical level of an interface between the etch stop pattern 394 and the outer backside insulating pattern 396. A horizontal-direction width of a second contact portion of the backside via contact MPV3, which passes through the outer backside insulating pattern 396, may be greater than a horizontal-direction width of a first contact portion of the backside via contact MPV3, which passes through the etch stop pattern 394.

As shown in FIGS. 6A and 6C, the backside via contact MPV3 may include the first contact portion, which passes through the etch stop pattern 394, and the second contact portion, which passes through the outer backside insulating pattern 396. In the backside via contact MPV3, the first and second contact portions may be integrally connected to each other. In the backside via contact MPV3, a sidewall of the first contact portion may be in contact with the etch stop pattern 394, and a sidewall of the second contact portion may be in contact with the outer backside insulating pattern 396. In the backside via contact MPV3, the sidewall of the second contact portion may not be in contact with the etch stop pattern 394.

In the backside via contact MPV3, the stepped portion ST3 may have a ring shape, which surrounds the perimeter of the backside via contact MPV3, at the second vertical level LV32 corresponding to the vertical level of the interface between the etch stop pattern 394 and the outer backside insulating pattern 396. In the backside via contact MPV3, a vertical central axis of the first contact portion, which passes through the etch stop pattern 394, and a vertical central axis of the second contact portion, which passes through the outer backside insulating pattern 396, may be aligned with each other to extend along a straight line in the vertical direction (Z direction).

The metal silicide film 198 may be arranged between the backside via contact MPV3 and the source/drain region 130. The backside via contact MPV3 may be in contact with the metal silicide film 198. The backside via contact MPV3 may be configured to be connected to the source/drain region 130 via the metal silicide film 198.

In some example embodiments, an end portion of the backside via contact MPV3, which is farthest from the source/drain region 130, may be connected to a backside power rail MPR3. The backside power rail MPR3 may have a line shape linearly extending lengthwise in the first horizontal direction (X direction). The backside insulating structure BIS3 may surround a sidewall of the backside power rail MPR3. In some example embodiments, the backside via contact MPV3 and the backside power rail MPR3 may be integrally connected to each other and include the same material. In some example embodiments, the backside via contact MPV3 and the backside power rail MPR3 may be respectively formed in separate processes, and here, there may be an interface between the backside via contact MPV3 and the backside power rail MPR3. More detailed configurations of the backside via contact MPV3 and the backside power rail MPR3 are substantially the same as those of the backside via contact MPV and the backside power rail MPR, which are described with reference to FIGS. 2 and 3A to 3C.

In the integrated circuit device 300, the place holder 106 may have an upper surface contacting the source/drain region 130, a sidewall facing the backside via contact MPV3 in the horizontal direction (for example, the X direction) with a portion of the etch stop pattern 394 therebetween, and a lower surface contacting the outer backside insulating pattern 396. The etch stop pattern 394 of the backside insulating structure BIS3 may include a portion contacting the sidewall of the place holder 106. The place holder 106 may be apart from the backside via contact MPV3 in the horizontal direction (for example, the X direction and/or the Y direction) and may be arranged at a vertical level that is equal or similar to a portion of the backside via contact MPV3 in the horizontal direction (for example, the X direction and/or the Y direction). The place holder 106 may include a different material from a constituent material of each of the etch stop pattern 394 and the outer backside insulating pattern 396. Specific examples of the constituent material of the place holder 106 are the same as described with reference to FIGS. 3A and 3C.

As shown in FIG. 6C, the device isolation film 112 may include a portion between the backside via contact MPV3 and the place holder 106. The upper surface of the device isolation film 112 may be in contact with the gate dielectric film 152, and the lower surface of the device isolation film 112 may be in contact with the outer backside insulating pattern 396. The device isolation film 112 may include portions, which are in contact with the backside via contact MPV3, and portions, which are in contact with the place holder 106.

According to the integrated circuit device 300 described with reference to FIGS. 6A to 6C, similar to the integrated circuit device 100 described with reference to FIGS. 2 and 3A to 3C, in the integrated circuit device 300, a sufficient insulating distance may be secured or may be more likely to be secured between a plurality of backside via contacts MPV3 and between the plurality of source/drain contacts CA, thereby suppressing parasitic capacitance. Therefore, an unintended short-circuit between a plurality of conductive regions may be prevented or reduced in likelihood of occurring in the integrated circuit device 300, and the reliability of the integrated circuit device 300 may improve. Alternatively or additionally, the integrated circuit device 300 includes the backside via contact MPV3, and the backside insulating structure BIS3 surrounding the backside via contact MPV3 includes the etch stop pattern 394. Therefore, during a fabrication process of the integrated circuit device 300, to form the backside via contact MPV3, when a via hole is formed through a portion of the backside insulating structure BIS3 in the vertical direction (Z direction) from the backside of the backside insulating structure BIS3, it may be prevented or reduced in likelihood that the via hole unintentionally reaches up to another conductive line, for example, the gate line 160, the source/drain region 130, or a region adj acent thereto, on the frontside of the integrated circuit device 300. Therefore, the integrated circuit device 300 according to embodiments of the inventive concept may provide a more stable and an improved or optimized wiring structure even in an area reduced due to down-scaling, and thus, the degree of integration and the reliability of the integrated circuit device 300 may improve.

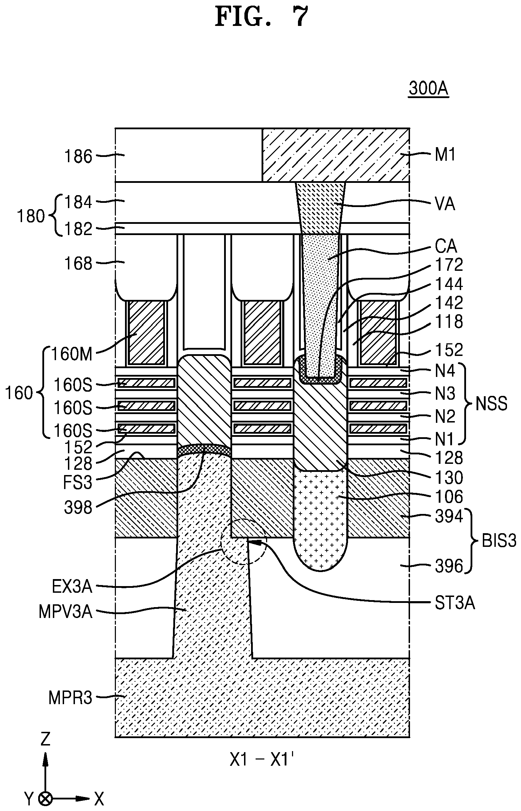

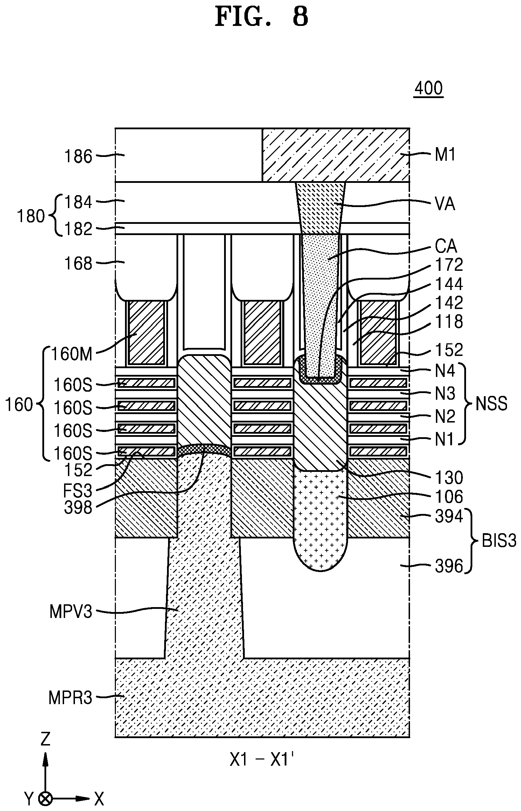

FIGS. 7 and 8 are cross-sectional views respectively illustrating integrated circuit devices 300A and 400 according to some example embodiments. FIGS. 7 and 8 respectively illustrate cross-sectional configurations of portions of the integrated circuit devices 300A and 400, which correspond to the cross-section taken along the line X1-X1' of FIG. 2. In FIGS. 7 and 5, the same reference numerals as in FIGS. 2 to 6C respectively denote the same members, and here, repeated descriptions thereof are omitted. Components shown in FIG. 7 or 8 may constitute a portion of the plurality of cells LC shown in FIG. 1.

Referring to FIG. 7, the integrated circuit device 300A may have substantially the same configuration as the integrated circuit device 300 described with reference to FIGS. 6A to 6C. However, the integrated circuit device 300A includes a backside via contact MPV3A passing through the backside insulating structure BIS3.

The backside via contact MPV3A may have substantially the same configuration as the backside via contact MPV3 described with reference to FIGS. 6A to 6C. However, as shown in a region EX3A, the backside via contact MPV3A may include a stepped portion ST3A. The stepped portion ST3A of the backside via contact MPV3A may be formed to be biased toward one side in the horizontal direction from a central axis of the backside via contact MPV3A, the central axis extending in the length direction (that is, the Z direction in FIG. 7) of the backside via contact MPV3A. That is, the stepped portion ST3A of the backside via contact MPV3A may be formed in only a portion of the perimeter of the backside via contact MPV3A.

The stepped portion ST3A of the backside via contact MPV3A may be arranged apart from the plurality of gate lines 160 in the vertical direction (Z direction) and may include a portion of the backside via contact MPV3A, which has a change in the width of the backside via contact MPV3A in the horizontal direction (for example, the X direction), at a vertical level adjacent to the etch stop pattern 394 pierced by the backside via contact MPV3A.

The backside via contact MPV3A may include a first contact portion, which passes through the etch stop pattern 394, and a second contact portion, which passes through the outer backside insulating pattern 396. The first and second contact portions may be integrally connected to each other. A horizontal-direction width of the first contact portion of the backside via contact MPV3A, which passes through the etch stop pattern 394, may be less than a horizontal-direction width of the second contact portion of the backside via contact MPV3A, which passes through the outer backside insulating pattern 396. In the backside via contact MPV3A, a vertical central axis of the first contact portion, which passes through the etch stop pattern 394, and a vertical central axis of the second contact portion, which passes through the outer backside insulating pattern 396, may be misaligned with each other in the horizontal direction.

A metal silicide film 398 may be arranged between the backside via contact MPV3A and the source/drain region 130. The backside via contact MPV3A may be configured to be connected to the source/drain region 130 via the metal silicide film 398. An end portion of the backside via contact MPV3A, which is farthest from the source/drain region 130, may be connected to the backside power rail MPR3. The backside via contact MPV3A and the backside power rail MPR3 may be integrally connected to each other and may include the same material. More detailed configurations of the metal silicide film 398, the backside via contact MPV3A, and the backside power rail MPR3 are substantially the same as those of the metal silicide film 198, the backside via contact MPV, and the backside power rail MPR, which are described with reference to FIGS. 3A and 3C.

Referring to FIG. 8, the integrated circuit device 400 may have substantially the same configuration as the integrated circuit device 300 described with reference to FIGS. 6A to 6C. However, the integrated circuit device 400 does not include the bottom insulating structure 128 shown in FIGS. 6A and 6B.

In the integrated circuit device 400, each of the plurality of gate lines 160 may be arranged over the inner backside insulating pattern 192 to cover the plurality of nanosheet stacks NSS and may include four sub-gate portions 160S surrounding at least portions of the first to fourth nanosheets N1, N2, N3, and N4. The gate dielectric film 152 may be arranged between the etch stop pattern 394 and the sub-gate portion 160S that is closest to the etch stop pattern 394 from among the four sub-gate portions 160S, and the frontside surface FS3 of the backside insulating structure BIS3 may be in contact with the gate dielectric film 152.

Next, a method of fabricating an integrated circuit device, according to some example embodiments, is described in detail.

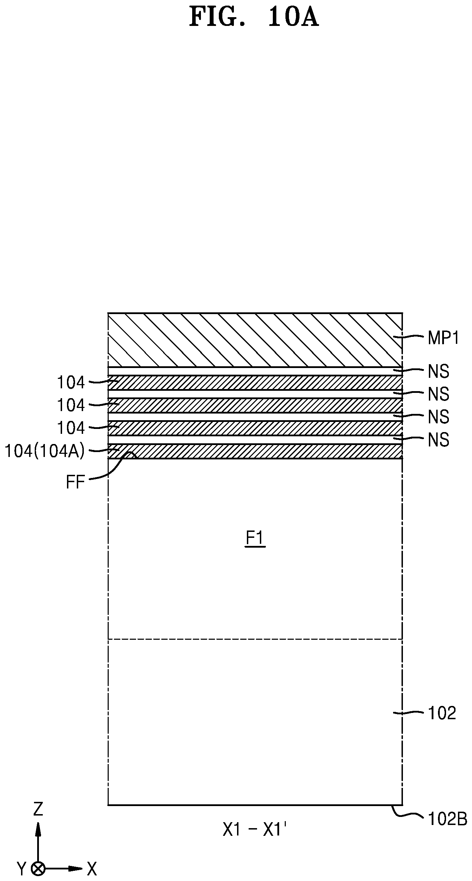

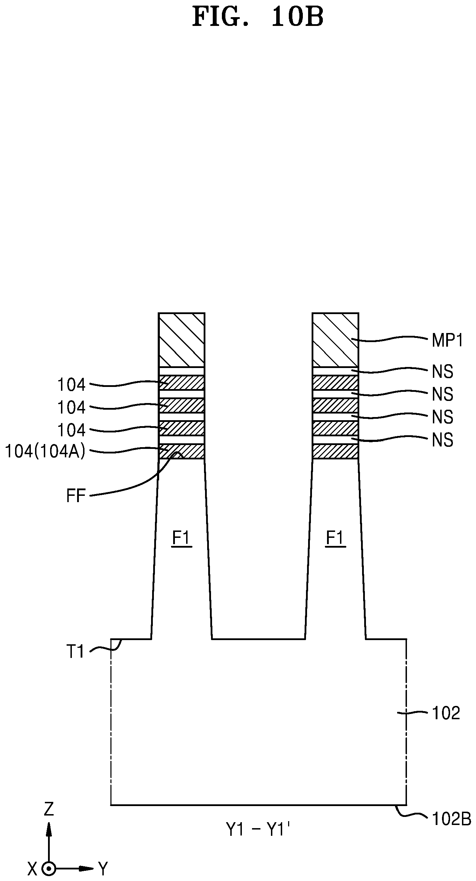

FIGS. 9A to 24C are diagrams respectively illustrating a sequence of processes of a method of fabricating an integrated circuit device, according to some example embodiments. More specifically, FIGS. 9A, 10A, ..., and 24A are cross-sectional views each illustrating an example of a cross-sectional structure of a portion of the integrated circuit device, which corresponds to the cross-section taken along the line X1-X1' of FIG. 2, according to the sequence of processes. FIGS. 9B, 10B, ..., and 24B are cross-sectional views each illustrating an example of a cross-sectional structure of a portion of the integrated circuit device, which corresponds to the cross-section taken along the line Y1-Y1' of FIG. 2, according to the sequence of processes. FIGS. 12C, 13C, 18C, 19C, ..., and 24C are cross-sectional views each illustrating an example of a cross-sectional structure of a portion of the integrated circuit device, which corresponds to the cross-section taken along the line Y2-Y2' of FIG. 2, according to the sequence of processes.

An example of a method of fabricating the integrated circuit device 100 described with reference to FIGS. 2 and 3A to 3C is described with reference to FIGS. 9A to 24C. In FIGS. 9A to 24C, the same reference numerals as in FIGS. 2 and 3A to 3C respectively denote the same members, and here, repeated descriptions thereof are omitted.

Referring to FIGS. 9A and 9B, a substrate 102 having a frontside surface 102F and a backside surface 102B, which are opposite to each other, may be prepared, and a stack structure, in which a plurality of sacrificial semiconductor layers 104 and a plurality of nanosheet semiconductor layers NS are alternately stacked one-by-one, may be formed on the frontside surface 102F of the substrate 102. In the stack structure, a sacrificial semiconductor layer 104, which is closest to the substrate 102, from among the plurality of sacrificial semiconductor layers 104 may be referred to as a bottom sacrificial semiconductor layer 104A. The stack structure may be formed, e.g., with an atomic layer deposition (ALD) process including a plasma-enhanced chemical vapor deposition (PECVD) process and/or a furnace deposition process; example embodiments are not limited thereto.

In the stack structure, each of the plurality of sacrificial semiconductor layers 104 and each of the plurality of nanosheet semiconductor layers NS may respectively include semiconductor materials having different etch selectivities (e.g., etch rates) from each other. In some example embodiments, each of the plurality of nanosheet semiconductor layers NS may include a Si layer and each of the plurality of sacrificial semiconductor layers 104 may include a SiGe layer. The SiGe layer constituting the sacrificial semiconductor layer 104 may have a constant Ge content selected from a range of about 5 at% to about 50 at%, for example, about 10 at% to about 40 at%. In some example embodiments, each of the plurality of sacrificial semiconductor layers 104 may include a SiGe layer and the respective Ge contents of the plurality of sacrificial semiconductor layers 104 may be equal to each other. In some example embodiments, each of the plurality of sacrificial semiconductor layers 104 may include a SiGe layer, and the Ge content of the sacrificial semiconductor layer 104, which is closest to the substrate 102, from among the plurality of sacrificial semiconductor layers 104 may be different from the Ge contents of other semiconductor layers 104. For example, the Ge content of the sacrificial semiconductor layer 104, which is closest to the substrate 102, from among the plurality of sacrificial semiconductor layers 104 may be greater than the Ge contents of other semiconductor layers 104, but embodiments of the inventive concept are not limited thereto.

Referring to FIGS. 10A and 10B, a mask pattern MP1 having openings, which expose the upper surface of the stack structure, may be formed on the resulting product of FIGS. 9A and 9B. The mask pattern MP1 may include a stack structure of a silicon oxide film pattern and a silicon nitride film pattern. The mask pattern MP1 may include portions extending parallel to each other in the first horizontal direction (X direction) over the substrate 102.

Each of the plurality of sacrificial semiconductor layers 104, the plurality of nanosheet semiconductor layers NS, and the substrate 102 may be partially etched by using the mask pattern MP1 as an etch mask, thereby forming a plurality of fin-type active regions F1 in the substrate 102. The partial etching may be performed with a dry etching process and/or a wet etching process; example embodiments are not limited thereto. A plurality of trench regions T1 may be defined on the substrate 102 by the plurality of fin-type active regions F1. A portion of each of the plurality of sacrificial semiconductor layers 104 and the plurality of nanosheet semiconductor layers NS may remain on a fin top surface FF of each of the plurality of fin-type active regions F1. The bottom sacrificial semiconductor layer 104A, which is closest to the substrate 102 from among the plurality of sacrificial semiconductor layers 104, may be in contact with the fin top surface FF of the fin-type active region F1.

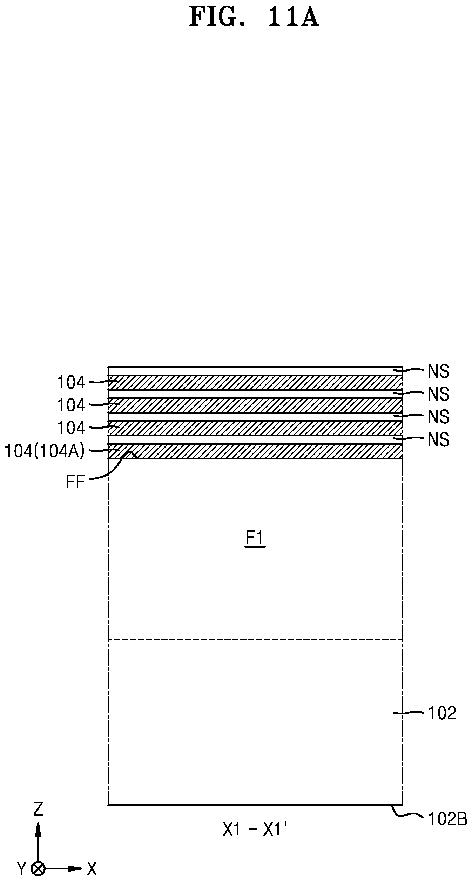

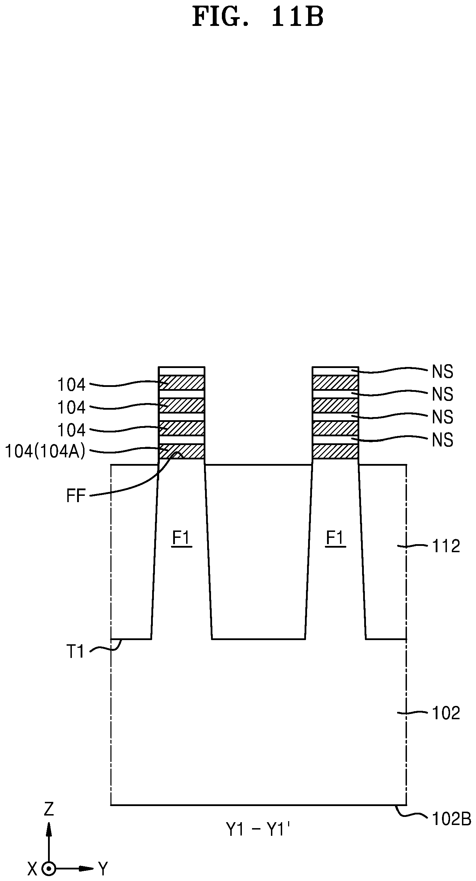

Referring to FIGS. 11A and 11B, the device isolation film 112 may be formed on the resulting product of FIGS. 10A and 10B. The device isolation film 112 may be formed to fill the plurality of trench regions T1 and cover a sidewall of each of the plurality of fin-type active regions F1.

To form the device isolation film 112, an insulating film may be formed on the resulting product of FIGS. 10A and 10B to have a thickness enough to fill the plurality of trench regions T1, and the upper surface of the mask pattern MP1 may be exposed by planarizing the obtained resulting product. The insulating film may be formed with a spin-on glass (SOG) process; however, example embodiments are not limited thereto. Next, the mask pattern MP1 that is exposed may be removed, followed by performing a recess process for removing a portion of the insulating film, thereby forming the device isolation film 112, which includes the remaining portion of the insulating film. After the device isolation film 112 is formed, the stack structure including the plurality of sacrificial semiconductor layers 104 and the plurality of nanosheet semiconductor layers NS, which remain on the substrate 102, may protrude upward from the upper surface of the device isolation film 112, and the upper surface of the uppermost nanosheet semiconductor layer NS from among the plurality of nanosheet semiconductor layers NS may be exposed.

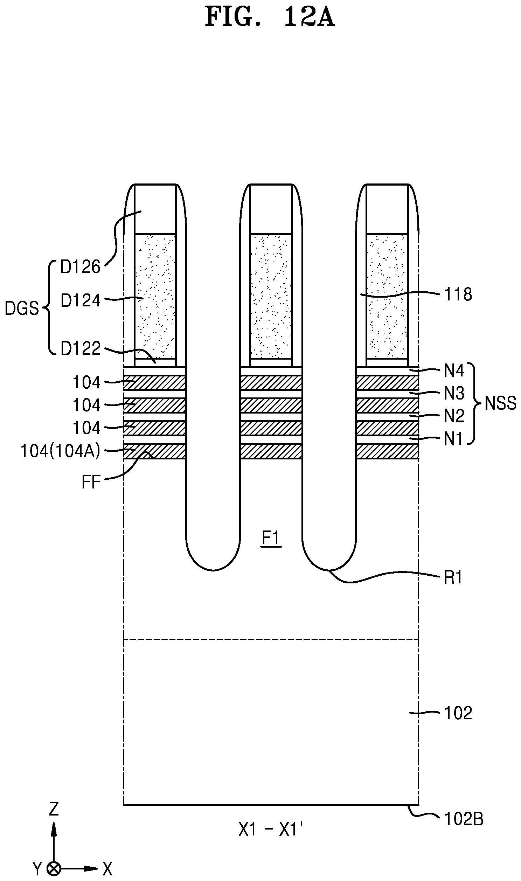

Referring to FIGS. 12A to 12C, a plurality of dummy gate structures DGS may be formed on the resulting product of FIGS. 11A and 11B. Each of the plurality of dummy gate structures DGS may be formed to extend lengthwise in the second horizontal direction (Y direction). Each of the plurality of dummy gate structures DGS may include a dummy oxide film D122, a dummy gate layer D124, and a capping layer D126, which are stacked in the stated order on the stack structure including the plurality of sacrificial semiconductor layers 104 and the plurality of nanosheet semiconductor layers NS. In some example embodiments, the dummy gate layer D124 may include polysilicon (such as doped or undoped polysilicon) and the capping layer D126 may include a silicon nitride film.

As shown in FIG. 12A, a plurality of insulating spacers 118 may be formed to respectively cover both sidewalls of each of the plurality of dummy gate structures DGS, and a portion of each of the plurality of sacrificial semiconductor layers 104 and the plurality of nanosheet semiconductor layers NS and a portion of the fin-type active region F1 may be etched by using the plurality of dummy gate structures DGS and the plurality of insulating spacers 118 as an etch mask, whereby the plurality of nanosheet semiconductor layers NS may be divided into the plurality of nanosheet stacks NSS, which each include the first to fourth nanosheets N1, N2, N3, and N4, and a plurality of recesses R1 may be formed in an upper portion of the fin-type active region F1. The width of each of the first to fourth nanosheets N1, N2, N3, and N4 in the first horizontal direction (X direction) may be defined by the plurality of recesses R1.

To form the plurality of recesses R1, the etching may be performed by dry etching, wet etching, or a combination thereof. During the formation of the plurality of insulating spacers 118 and the plurality of recesses R1, the plurality of side insulating spacers 119 may be formed as shown in FIG. 12C, the plurality of side insulating spacers 119 being arranged on the device isolation film 112 on both sides of each fin-type active region F1 in the second horizontal direction (Y direction) to be respectively adjacent to the plurality of recesses R1.

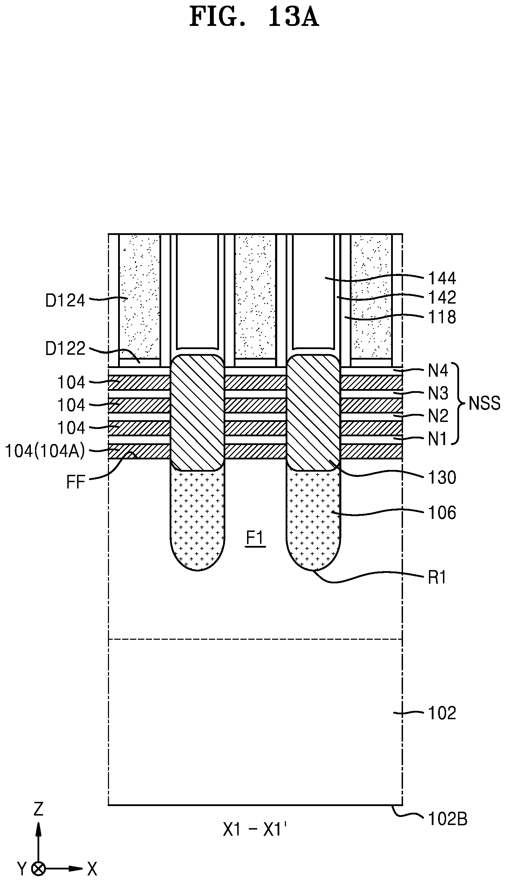

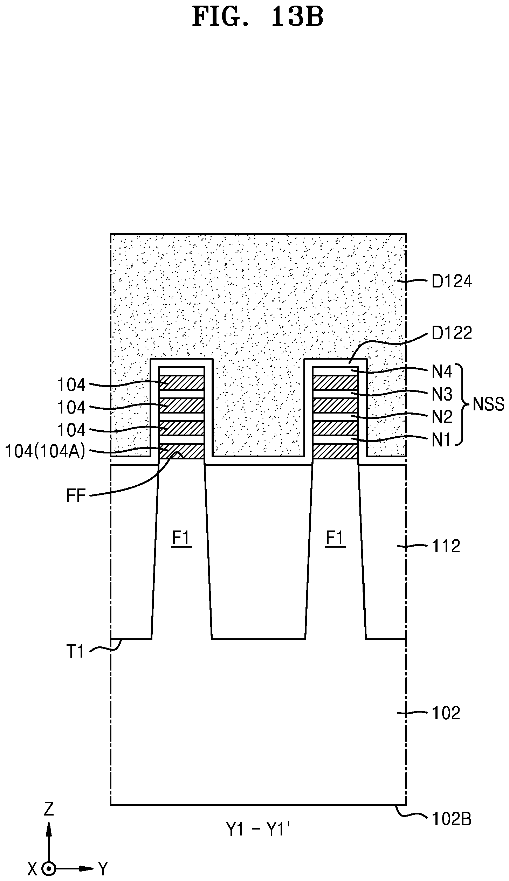

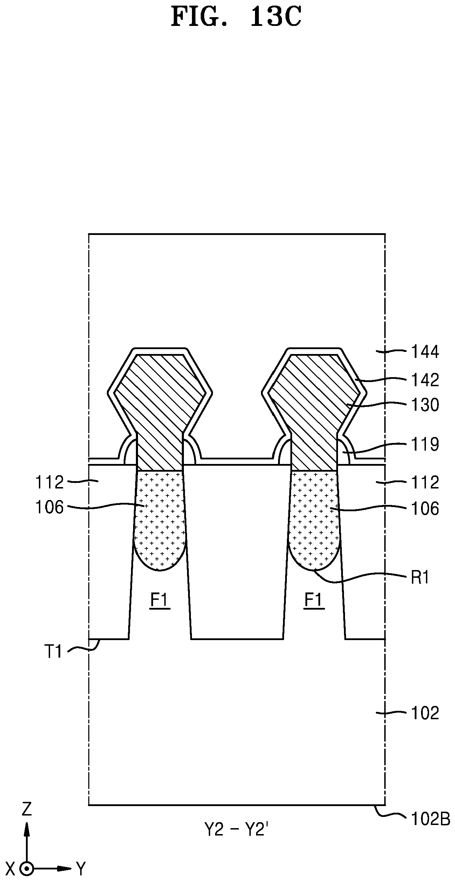

Referring to FIGS. 13A to 13C, in the resulting product of FIGS. 12A to 12C, aplurality of place holders 106 may be formed to respectively fill the plurality of recesses R1.

In some example embodiments, to form the plurality of place holders 106, a semiconductor material may be epitaxially grown on a surface of the fin-type active region F1, which is exposed in each of the plurality of recesses R1. Each of the plurality of place holders 106 may cover the fin-type active region F1 and fill a lower portion of each of the plurality of recesses R1. In some example embodiments, each of the plurality of place holders 106 may include a doped SiGe film or an undoped SiGe film. In some example embodiments, each of the plurality of place holders 106 may include a SiGe film having a Ge content, which is greater than the Ge content of the source/drain region 130 that is to be formed in each of the plurality of recesses R1 in a subsequent process. For example, the SiGe film constituting each of the plurality of place holders 106 may have, but is not limited to, a Ge content selected from a range of about 5 at% to about 50 at%, for example, about 10 at% to about 40 at%.

In some example embodiments, to form the plurality of place holders 106, a deposition process may be used. For example, in the resulting product of FIGS. 12A to 12C, an insulating film may be formed to fill the plurality of recesses R1, followed by performing etch-back on the insulating film, thereby forming the plurality of place holders 106, which respectively include the remaining portions of the insulating film. In some example embodiments, each of the plurality of place holders 106 may include, but is not limited to, an aluminum oxide film, a titanium oxide film, a silicon nitride film, or a combination thereof.

After the plurality of place holders 106 are formed, the sidewall of each of the first to fourth nanosheets N1, N2, N3, and N4 and the sidewall of each of the plurality of sacrificial semiconductor layers 104 may be exposed by the recess R1 over each of the plurality of place holders 106.

Next, the plurality of source/drain regions 130 may be formed on the plurality of place holders 106 to fill the plurality of recesses R1, respectively. To form the plurality of source/drain regions 130, a semiconductor material may be epitaxially grown on the sidewall of each of the first to fourth nanosheets N1, N2, N3, and N4 and the surface of the fin-type active region F1, which are exposed in each of the plurality of recesses R1. When each of the plurality of place holders 106 includes a SiGe film, the semiconductor material may be epitaxially grown on the surface of each of the plurality of place holders 106 while the plurality of source/drain regions 130 are formed.

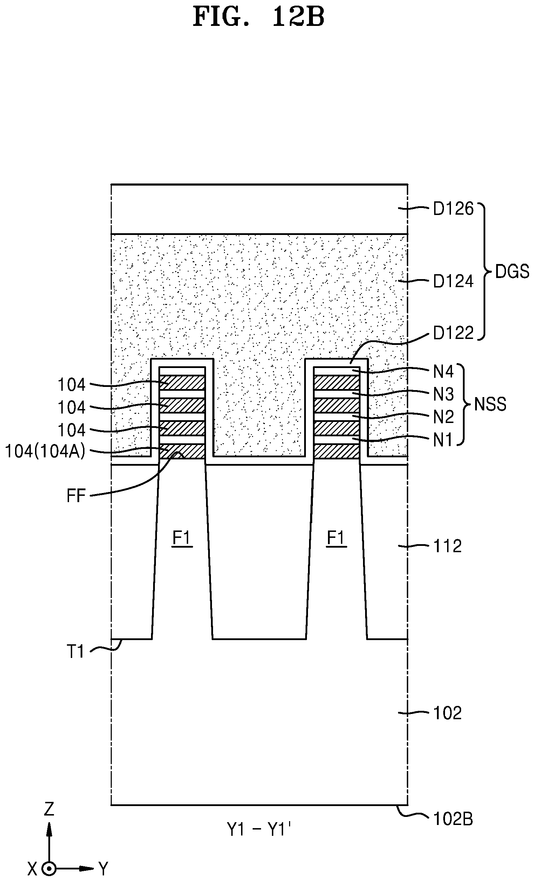

Next, the insulating liner 142 may be formed to cover a resulting product in which the plurality of source/drain regions 130 are formed, followed by forming the inter-gate dielectric 144 on the insulating liner 142, and then, each of the insulating liner 142 and the inter-gate dielectric 144 may be partially etched, thereby exposing upper surfaces of a plurality of capping layers D126 (see FIGS. 12A and 12B). Next, the dummy gate layer D124 may be exposed by removing the plurality of capping layers D126, and each of the insulating liner 142 and the inter-gate dielectric 144 may be partially removed such that the upper surface of the inter-gate dielectric 144 and the upper surface of the dummy gate layer D124 are at an approximately equal level.

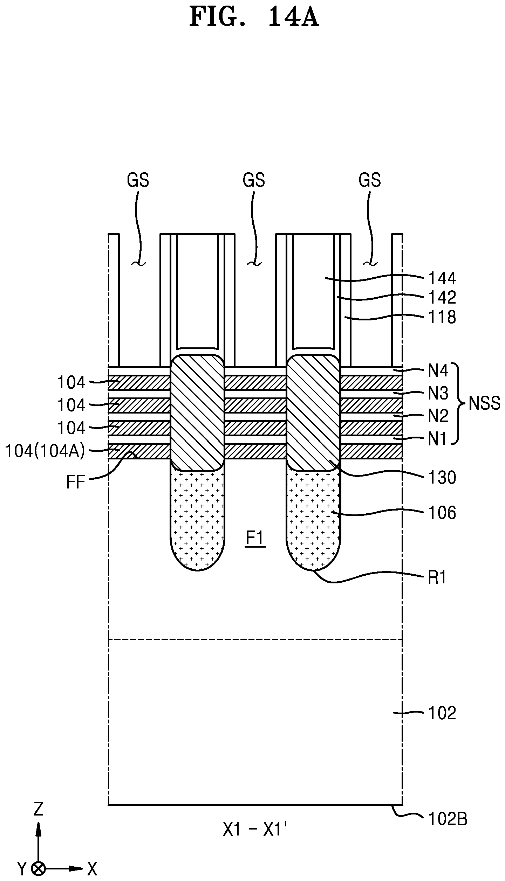

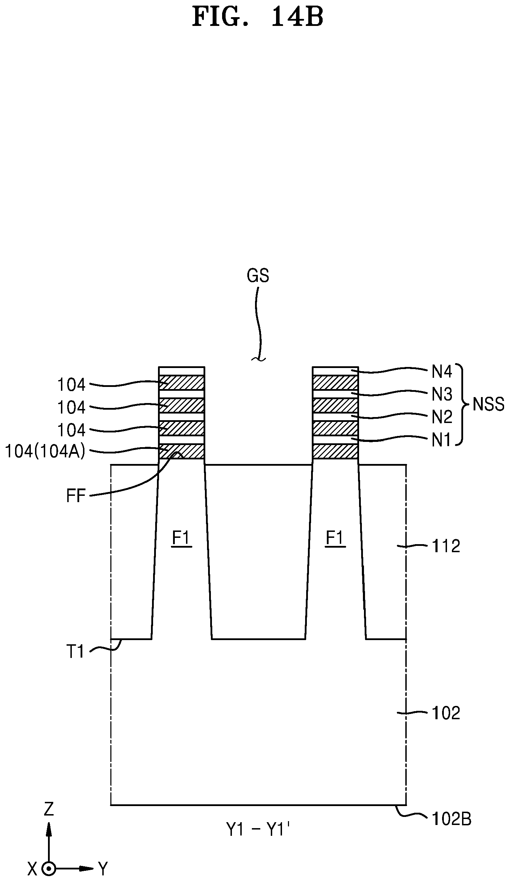

Referring to FIGS. 14A and 14B, the dummy gate layer D124 and the dummy oxide film D122 may be removed from the resulting product of FIGS. 13A to 13C, thereby preparing a gate space GS.

Referring to FIGS. 14A and 14B, in the resulting product of FIGS. 14A to 14C, the bottom sacrificial semiconductor layer 104A may be replaced with the bottom insulating structure 128 through the gate space GS.

In some example embodiments, to replace the bottom sacrificial semiconductor layer 104A with the bottom insulating structure 128, the bottom sacrificial semiconductor layer 104A from among the plurality of sacrificial semiconductor layers 104 may be selectively removed first by performing a selective etching process, which uses a difference in etch selectivity, on the resulting product of FIG. 14A to 14C, thereby forming a bottom space to expose the fin top surface FF of the fin-type active region F1 and the lower surface of the first nanosheet N1. Next, a buried insulating film, which has a sufficient thickness to fill the bottom space, may be formed by an atomic layer deposition (ALD) process, followed by removing a portion of the buried insulating film, thereby forming the bottom insulating structure 128 including a portion of the buried insulating film, which fills the bottom space. A constituent material of the buried insulating film is the same as the constituent material of the bottom insulating structure 128, which is described with reference to FIGS. 3A and 3B.

After the bottom insulating structure 128 is formed, the stack structure including the plurality of sacrificial semiconductor layers 104 and the first to fourth nanosheets N1, N2, N3, and N4 may be exposed by the gate space GS. The bottom insulating structure 128 may be in contact with at least one source/drain region 130, which is adjacent thereto in the first horizontal direction (X direction), from among the plurality of source/drain regions 130.

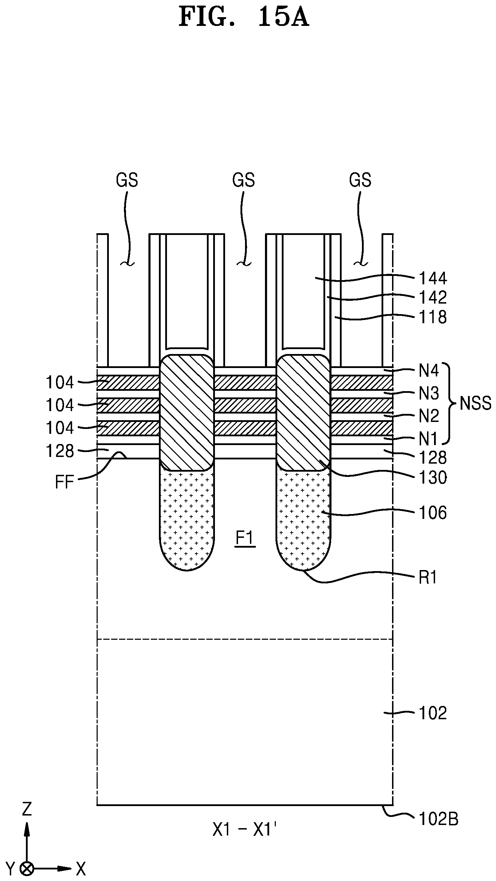

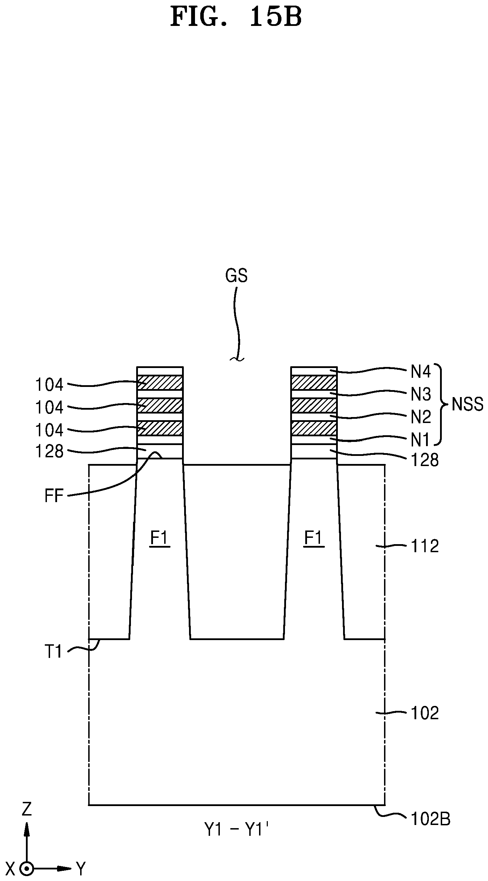

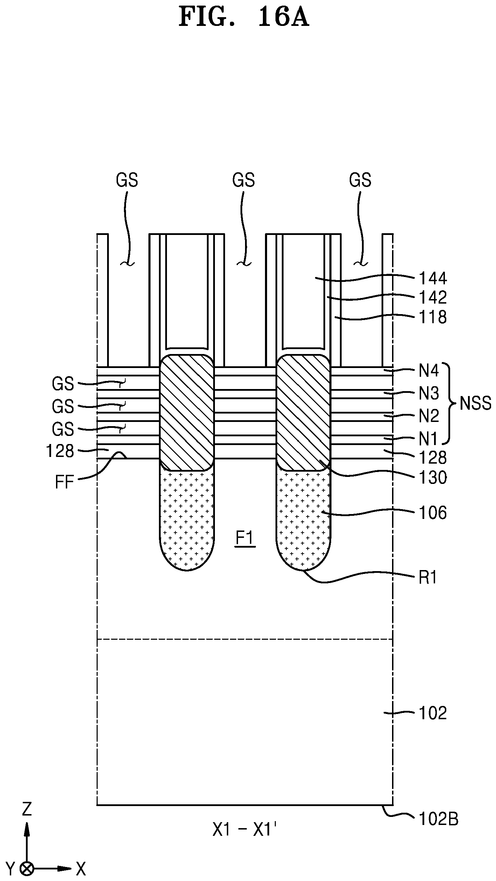

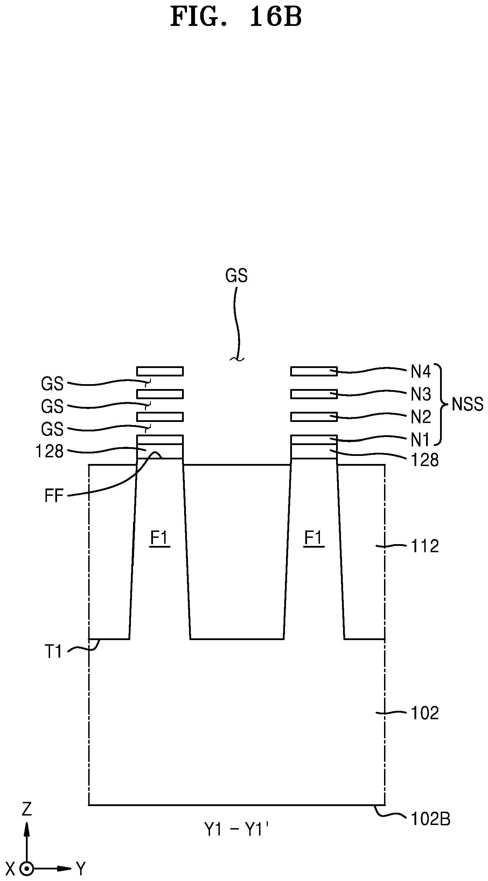

Referring to FIGS. 16A and 16B, the plurality of sacrificial semiconductor layers 104 remaining over the substrate 102 may be selectively removed from the resulting product of FIGS. 15A and 15B, thereby expanding the gate space GS up to each space between the first to fourth nanosheets N1, N2, N3, and N4.

In some example embodiments, to selectively remove the plurality of sacrificial semiconductor layers 104, a difference in etch selectivity between each of the plurality of sacrificial semiconductor layers 104 and each of the first to fourth nanosheets N1, N2, N3, and N4, the bottom insulating structure 128, and the fin-type active region F1 may be used. To selectively remove the plurality of sacrificial semiconductor layers 104, a liquid-phase or gas-phase etchant may be used. In some example embodiments, to selectively remove the plurality of sacrificial semiconductor layers 104, a CH₃COOH-based etching solution, for example, an etching solution including a mixture of CH₃COOH, HNO₃, and HF, or an etching solution including a mixture of CH₃COOH, H₂O₂, and HF, may be used, but embodiments of inventive concepts are not limited thereto.

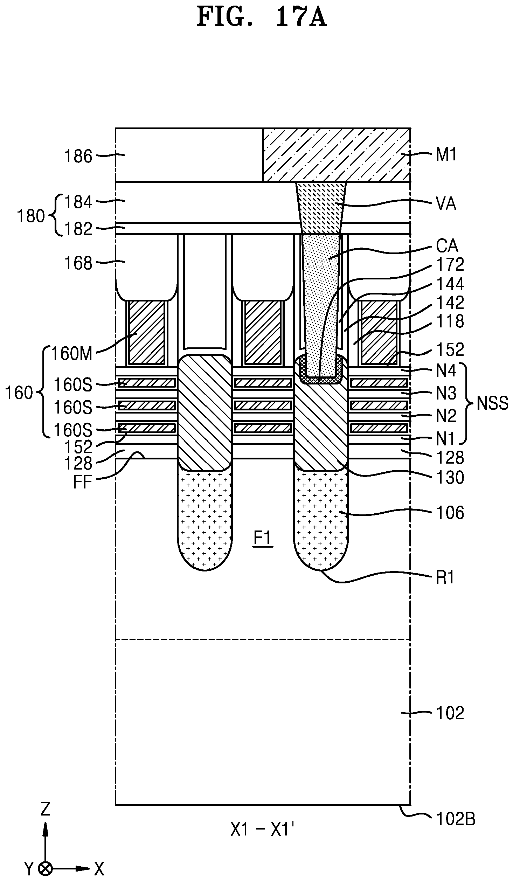

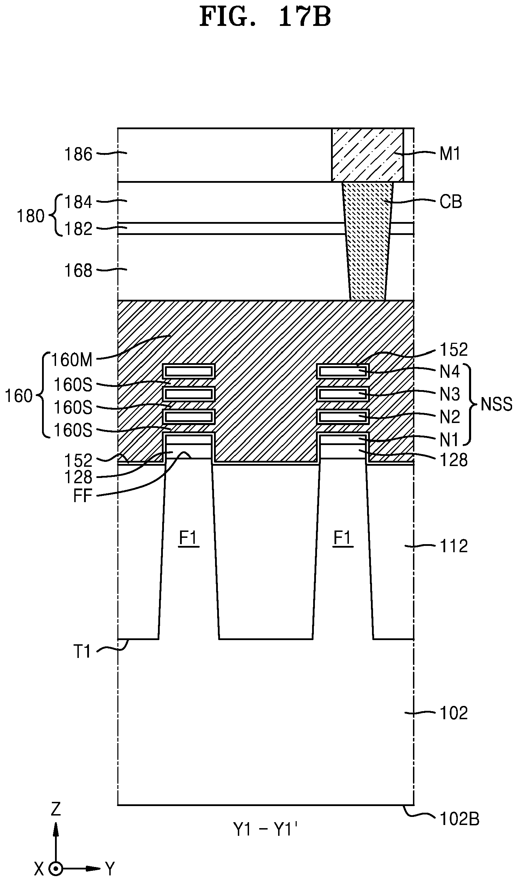

Referring to FIGS. 17A and 17B, in the resulting product of FIGS. 16A and 16B, the gate dielectric film 152 may be formed to cover respective exposed surfaces of the first to fourth nanosheets N1, N2, N3, and N4, the bottom insulating structure 128, and the fin-type active region F1. To form the gate dielectric film 152, an ALD process may be used; however, example embodiments are not limited thereto.

Next, the gate line 160 may be formed on the gate dielectric film 152 to fill the gate space GS (see FIGS. 16A and 16B). Next, each of the gate line 160, the gate dielectric film 152, and the insulating spacer 118 may be partially removed from the upper surface thereof to reduce the height thereof, and the plurality of capping insulating patterns 168 may each be formed to cover the upper surface of each of the gate line 160, the gate dielectric film 152, and the insulating spacer 118.

Next, a source/drain contact hole may be formed between two adjacent gate lines 160 from among the plurality of gate lines 160 to expose the source/drain region 130, followed by forming the metal silicide film 172 on the surface of the source/drain region 130 through the source/drain contact hole, and then, the source/drain contact CA may be formed on the metal silicide film 172 to fill the source/drain contact hole.

Next, the etch stop film 182 and the upper insulating film 184 may be formed in the stated order to cover the upper surface of each of the source/drain contact CA, the plurality of capping insulating patterns 168, and the inter-gate dielectric 144, thereby forming the upper insulating structure 180. Next, the source/drain via contact VA, which passes through the upper insulating structure 180 in the vertical direction (Z direction) to be connected to the source/drain contact CA, and the gate contact CB, which passes through the upper insulating structure 180 and the capping insulating pattern 168 in the vertical direction (Z direction) to be connected to the gate line 160, may be formed. The source/drain via contact VA and the gate contact CB may be simultaneously formed or may be separately formed by separate processes from each other. Next, the interlayer dielectric 186, which covers the upper insulating structure 180, and the plurality of upper wiring layers M1, which pass through the interlayer dielectric 186, may be formed. The plurality of upper wiring layers M1 may include an upper wiring layer M1 connected to the source/drain via contact VA and an upper wiring layer M1 connected to the gate contact CB. Next, a frontside wiring structure (not shown) may be formed on the interlayer dielectric 186 and the plurality of upper wiring layers M1.

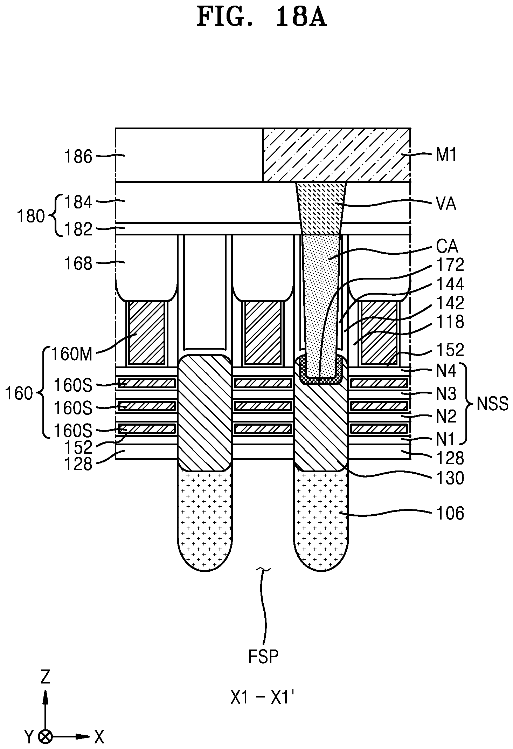

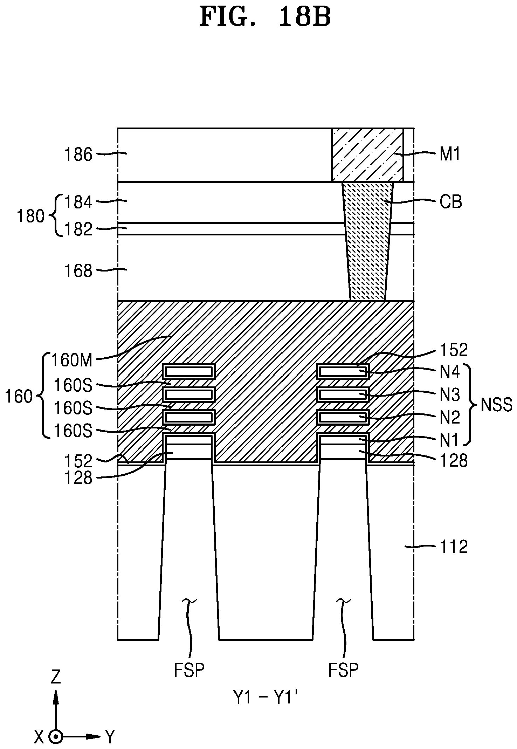

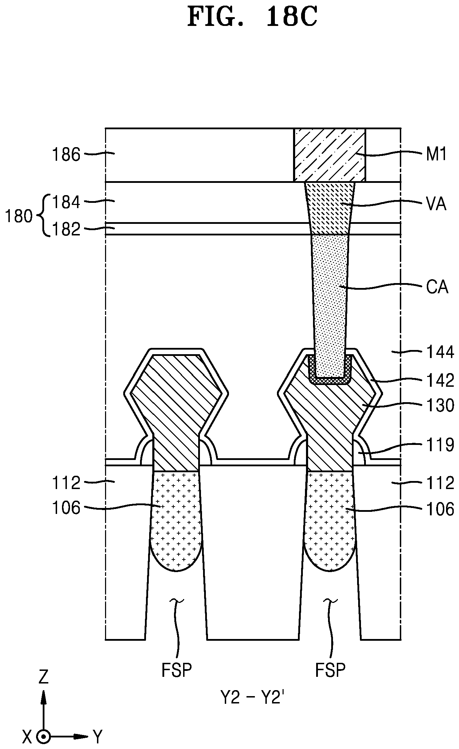

Referring to FIGS. 18A to 18C, the substrate 102 and the plurality of fin-type active regions F1 may be removed from the backside surface 102B (see FIGS. 17A and 17B) of the substrate 102. As a result, regions, which the plurality of fin-type active regions F1 have been located in but removed from, may remain as a plurality of fin spaces FSP. The width of each of the plurality of fin spaces FSP in the second horizontal direction (Y direction) may be defined by the device isolation film 112. A plurality of bottom insulating structures 128 and the plurality of place holders 106 may be exposed by the plurality of fin spaces FSP.

In some example embodiments, to remove or partially remove the substrate 102 and the plurality of fin-type active regions F1, at least one process selected from a mechanical grinding process, a chemical mechanical polishing (CMP) process, a wet etching process, and a combination thereof may be used. In some example embodiments, a front side of the semiconductor device may have a film and/or photoresist deposited thereon, prior to the backside removal of the substrate 102; example embodiments are not limited thereto.

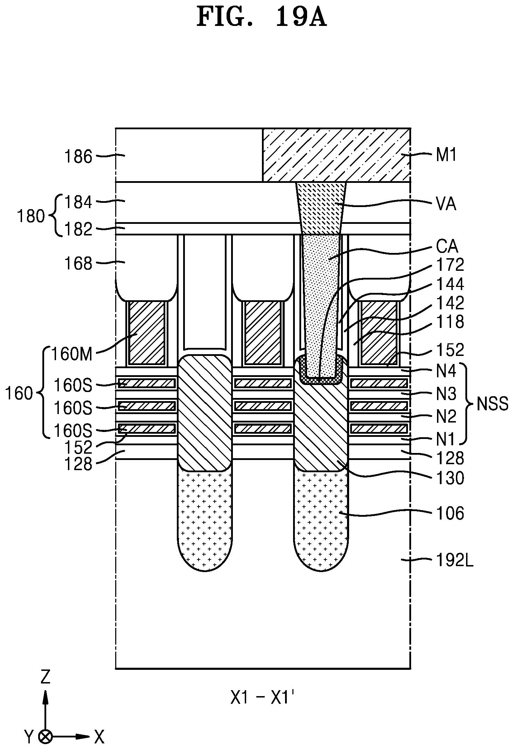

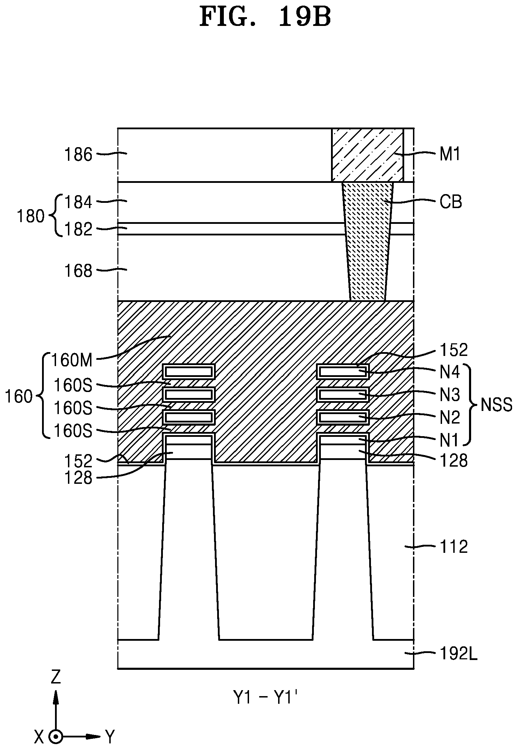

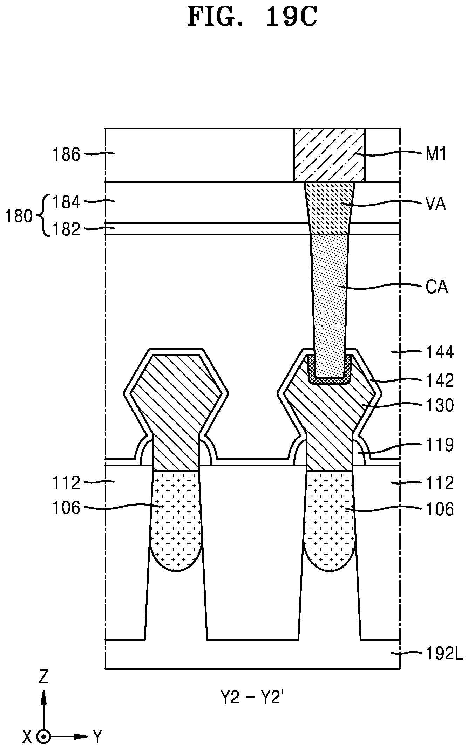

Referring to FIGS. 19A to 19C, in the resulting product of FIGS. 18A to 18C, an inner backside insulating film 192L may be formed to fill the plurality of fin spaces FSP and cover the device isolation film 112. A constituent material of the inner backside insulating film 192L is the same as the constituent material of the inner backside insulating pattern 192, which is described with reference to FIGS. 3A and 3B.

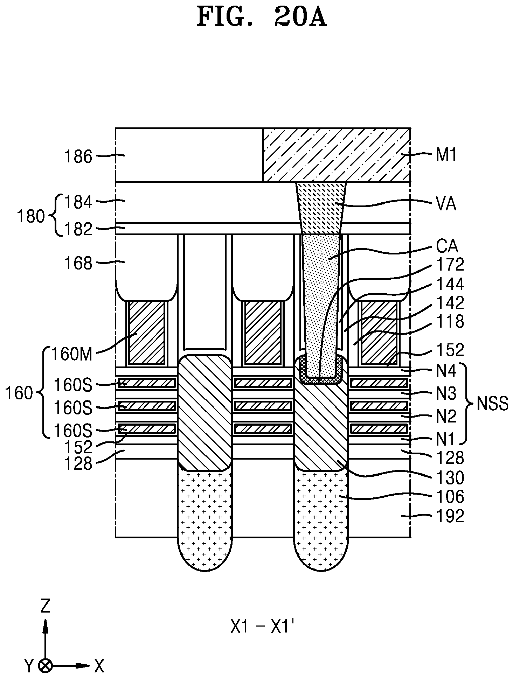

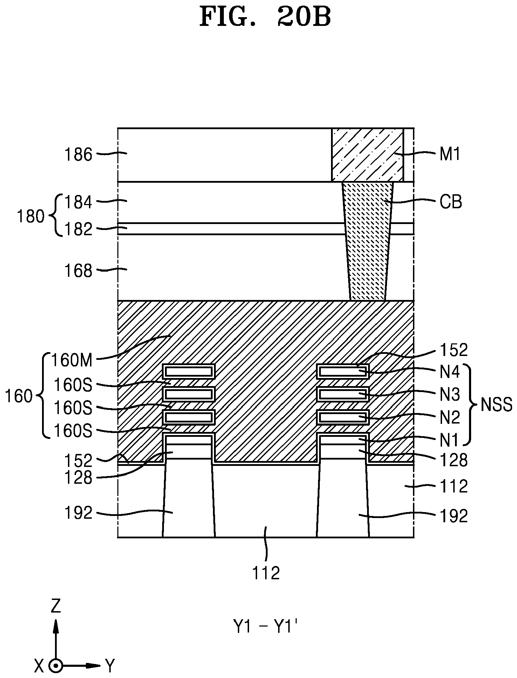

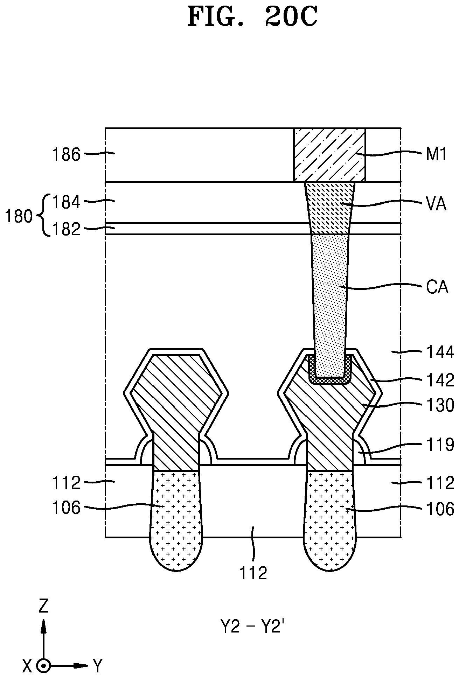

Referring to FIGS. 20A to 20C, a portion of each of the inner backside insulating film 192L and the device isolation film 112 may be removed from the resulting product of FIGS. 19A to 19C by a CMP process or an etch-back process, and thus, the thickness of each of the inner backside insulating film 192L and the device isolation film 112 in the vertical direction (Z direction) may be reduced, thereby forming the inner backside insulating pattern 192 from the inner backside insulating film 192L. Here, the respective etch selectivities of the inner backside insulating film 192L and the device isolation film 112 may be equal to or similar to each other, and the etch selectivity of each of the plurality of place holders 106 may be different from the respective etch selectivities of the inner backside insulating film 192L and the device isolation film 112. As a result, in a resulting product obtained after the portion of each of the inner backside insulating film 192L and the device isolation film 112 is removed from the resulting product of FIGS. 19A to 19C by a CMP process or an etch-back process, the respective lower surfaces of the inner backside insulating pattern 192 and the device isolation film 112 may be coplanar with each other, and the plurality of place holders 106 may protrude further than the respective lower surfaces of the inner backside insulating pattern 192 and the device isolation film 112.

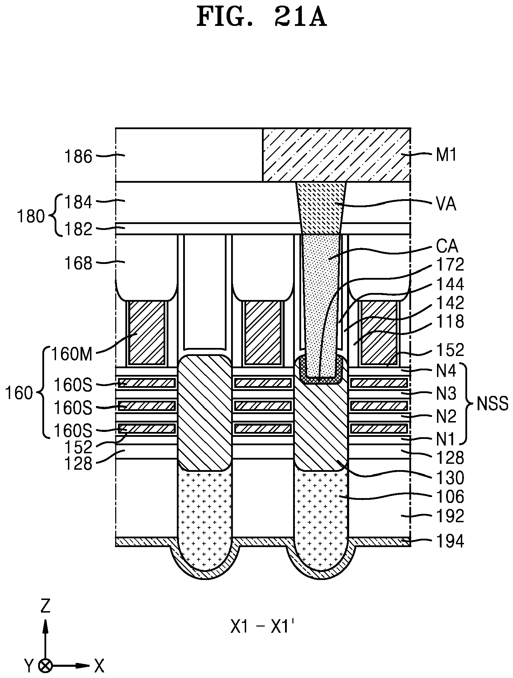

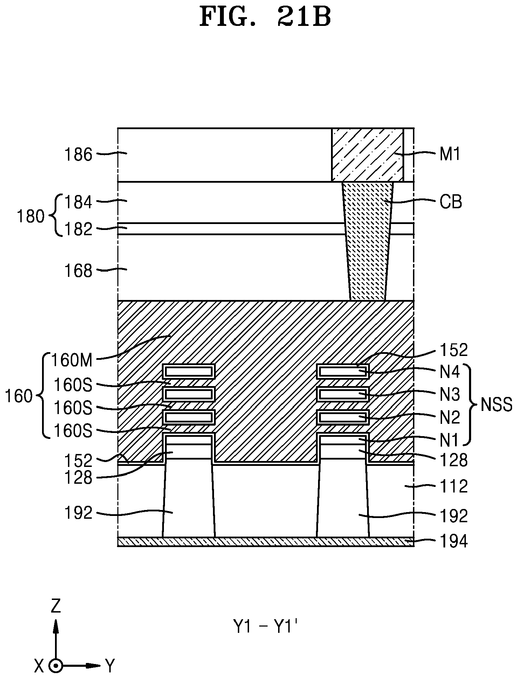

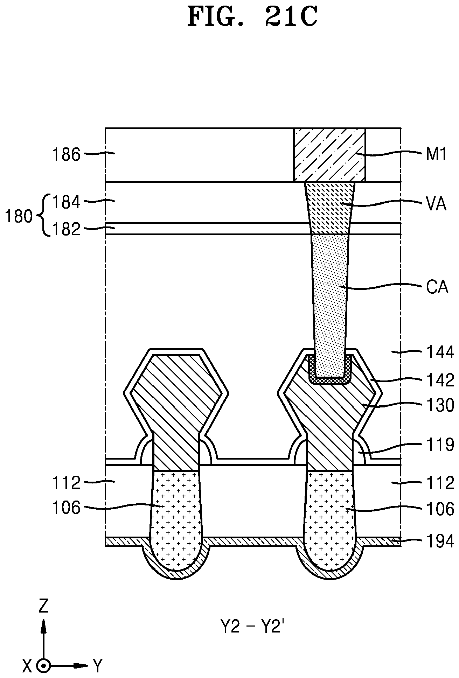

Referring to FIGS. 21A to 21C, in the resulting product of FIGS. 20A to 20C, the etch stop pattern 194 may be formed with a liner shape, e.g., with a CVD process, to cover or conformally cover the respective exposed surfaces of the inner backside insulating pattern 192, the device isolation film 112, and the plurality of place holders 106.

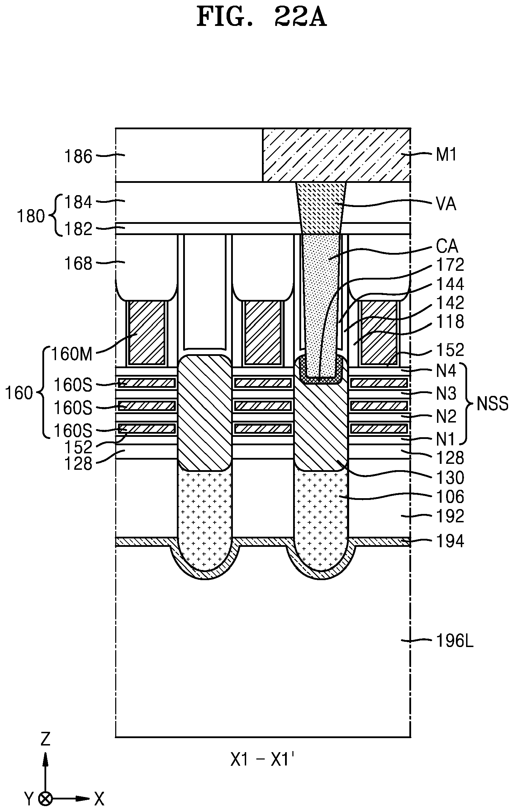

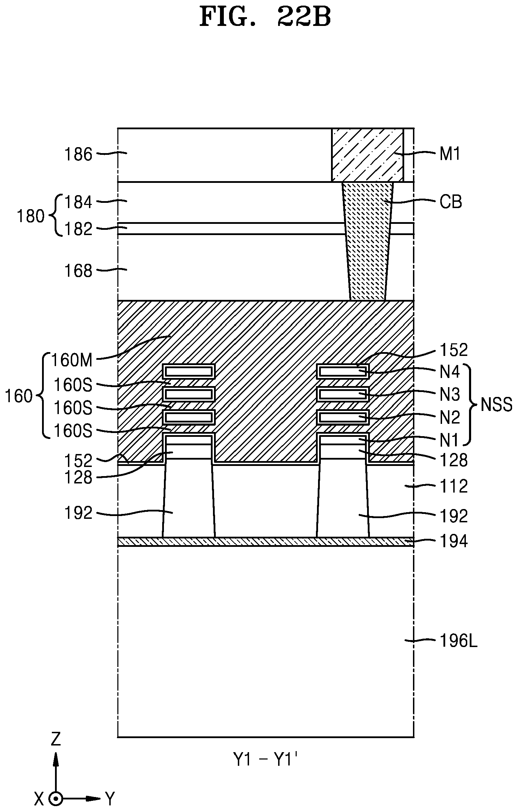

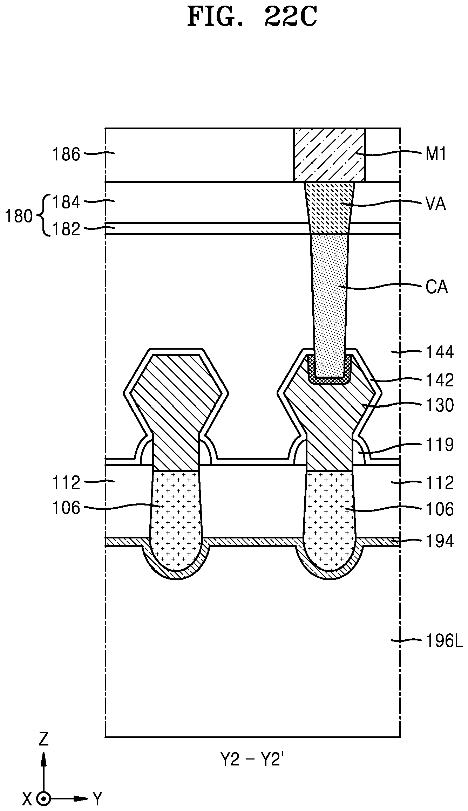

Referring to FIGS. 22A to 22C, an outer backside insulating film 196L may be formed to cover the etch stop pattern 194. A constituent material of the outer backside insulating film 196L is the same as the constituent material of the outer backside insulating pattern 196, which is described with reference to FIGS. 3A to 3C.

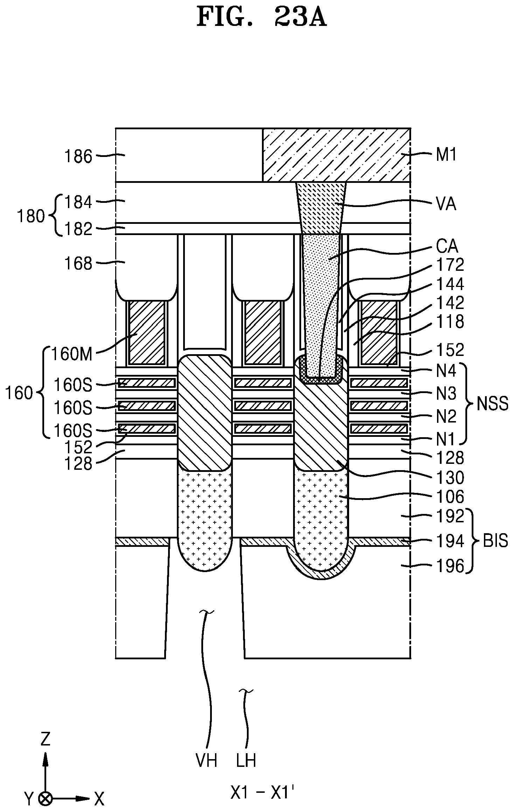

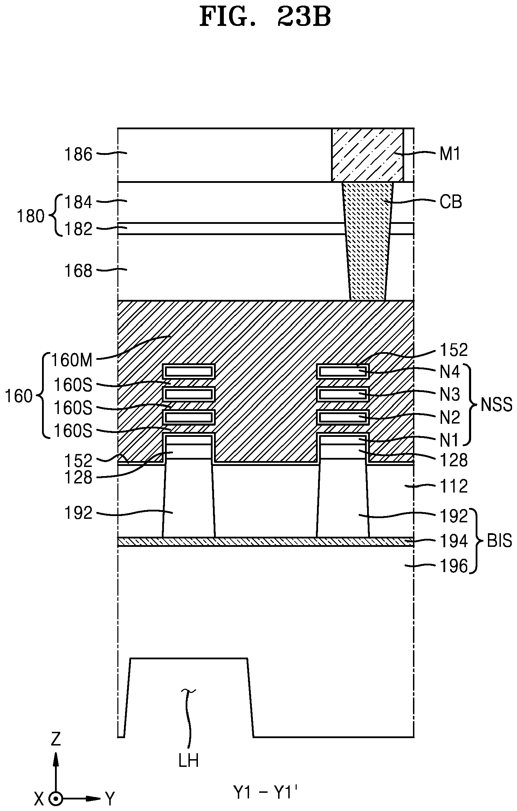

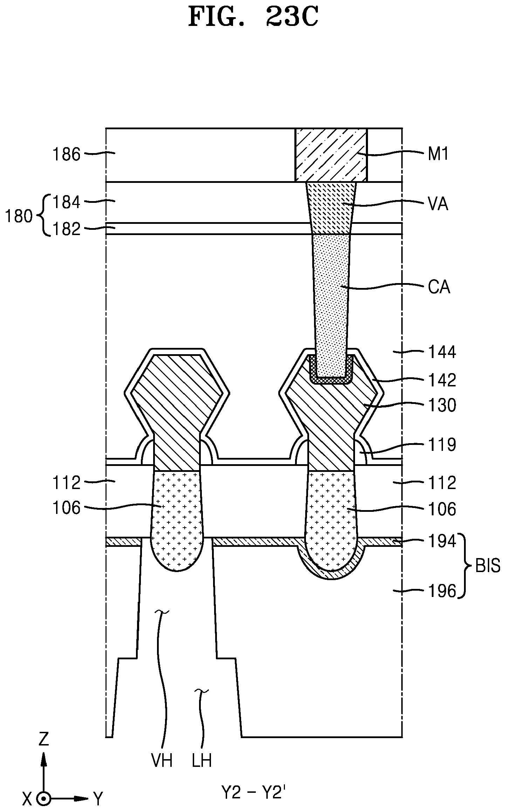

Referring to FIGS. 23A to 23C, a portion of the outer backside insulating film 196L may be etched by using the etch stop pattern 194 as an etch mask, whereby via holes VH, which respectively expose some place holders 106 selected from the plurality of place holders 106, and line holes LH, which are respectively connected to the via holes VH, may be formed. As a result, the outer backside insulating pattern 196, which defines a via hole VH and a line hole LH, may be obtained from the outer backside insulating film 196L. A portion of the etch stop pattern 194, which is exposed in an etching process for forming the via hole VH, may be removed, and the place holder 106 and each of the inner backside insulating pattern 192 and the device isolation film 112, which are therearound, may be exposed by the via hole VH. As shown in FIG. 23C, the length of the line hole LH in the vertical direction (Z direction) may be less than the length of the via hole VH in the vertical direction (Z direction), and the width of the line hole LH in the second horizontal direction (Y direction) may be greater than the width of the via hole VH in the second horizontal direction (Y direction).

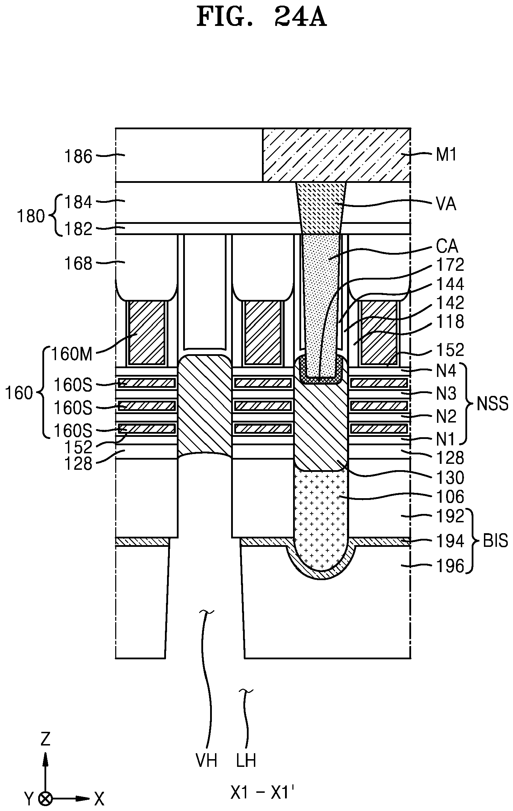

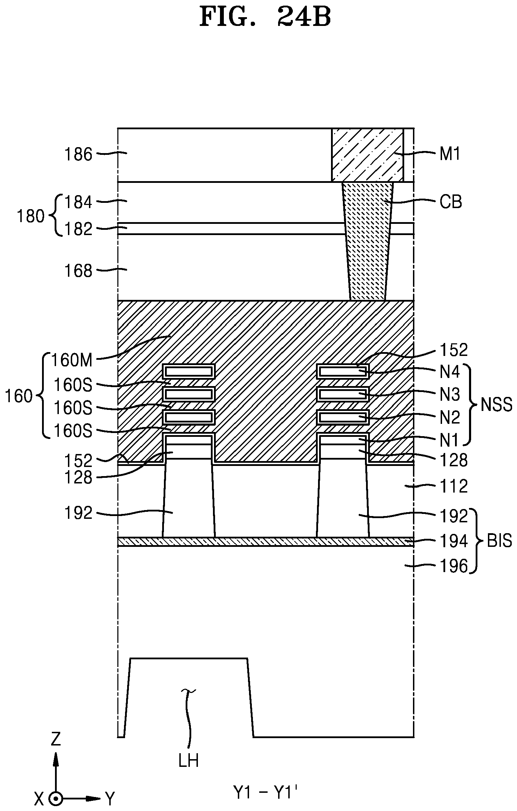

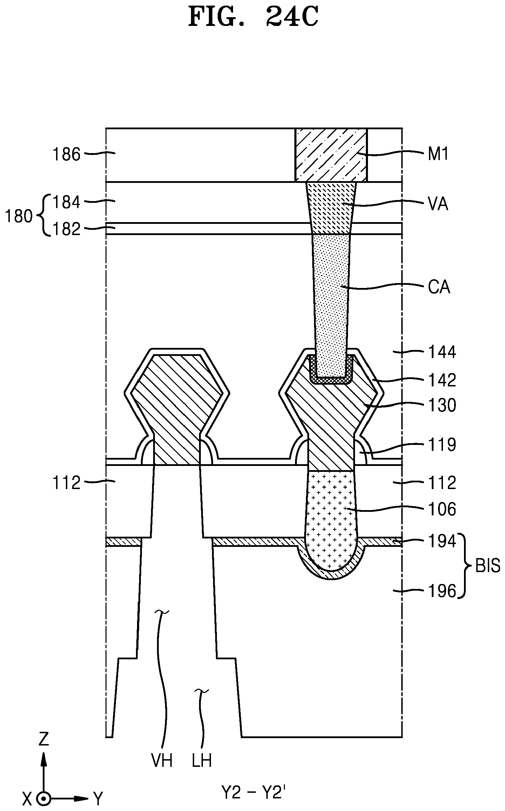

Referring to FIGS. 24A to 24C, the place holder 106, which is exposed by the line hole LH and the via hole VH, may be removed from the resulting product of FIGS. 23A to 23C, thereby exposing the source/drain region 130. While the source/drain region 130 is exposed by removing the place holder 106, a portion of the source/drain region 130 may be etched, and thus, a portion of the source/drain region 130, which is exposed by the via hole VH, may be reduced in the length thereof in the vertical direction (Z direction).

Next, a conductive material may fill the via hole VH and the line hole LH, thereby forming the backside via contact MPV and the backside power rail MPR, which are shown in FIGS. 3A to 3C.

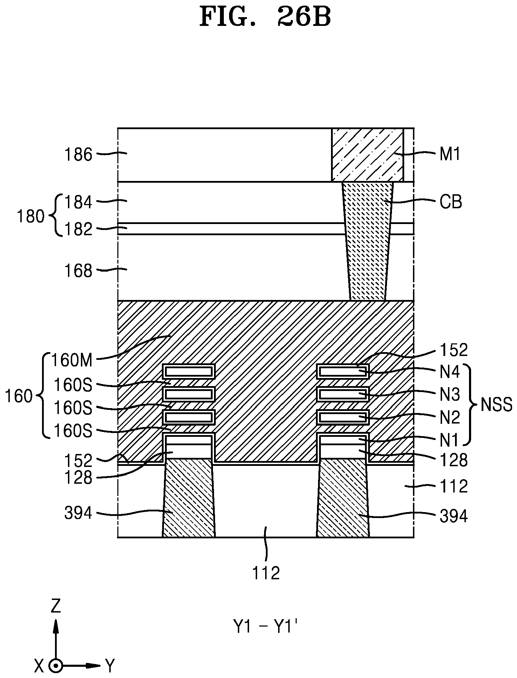

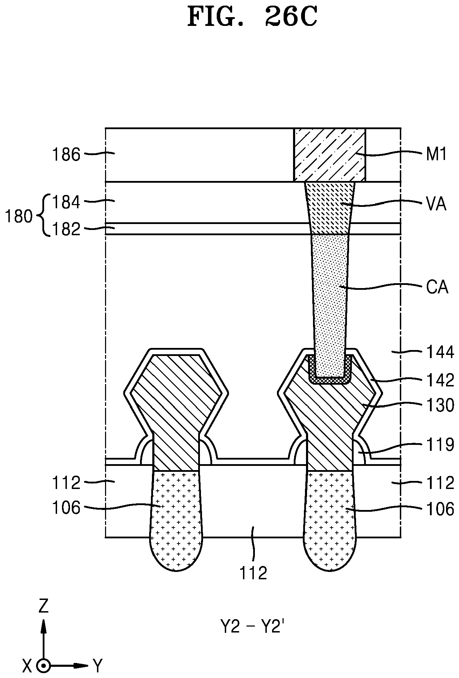

FIGS. 25A to 29C are diagrams respectively illustrating a sequence of processes of a method of fabricating an integrated circuit device, according to some example embodiments. More specifically, FIGS. 25A, 26A, ..., and 29A are cross-sectional views each illustrating an example of a cross-sectional structure of a portion of the integrated circuit device, which corresponds to the cross-section taken along the line X1-X1' of FIG. 2, according to the sequence of processes. FIGS. 25B, 26B, ..., and 29B are cross-sectional views each illustrating an example of a cross-sectional structure of a portion of the integrated circuit device, which corresponds to the cross-section taken along the line Y1-Y1' of FIG. 2, according to the sequence of processes. FIGS. 25C, 26C, ..., and 29C are cross-sectional views each illustrating an example of a cross-sectional structure of a portion of the integrated circuit device, which corresponds to the cross-section taken along the line Y2-Y2' of FIG. 2, according to the sequence of processes. An example of a method of fabricating the integrated circuit device 300 described with reference to FIGS. 6A to 6C is described with reference to FIGS. 25A to 29C. In FIGS. 25A to 29C, the same reference numerals as in FIGS. 2 to 6C respectively denote the same members, and here, repeated descriptions thereof are omitted.

Referring to FIGS. 25A to 25C, the processes described with reference to FIGS. 9A to 18C may be performed. Next, in the resulting product of FIGS. 18A to 18C, a gap-fill etch stop film 394L may be formed to fill the plurality of fin spaces FSP and cover the device isolation film 112. The gap-fill etch stop film 394L may fill each gap between the plurality of place holders 106. A constituent material of the gap-fill etch stop film 394L is the same as the constituent material of the etch stop pattern 394, which is described with reference to FIGS. 6A and 6B.

Referring to FIGS. 26A to 26C, each of the gap-fill etch stop film 394L and the device isolation film 112 may be partially removed from the resulting product of FIGS. 25A to 25C by a CMP process or an etch-back process, thereby reducing the thickness of each of the gap-fill etch stop film 394L and the device isolation film 112 in the vertical direction (Z direction). As a result, the etch stop pattern 394 may be obtained from the gap-fill etch stop film 394L. As a result, the respective lower surfaces of the etch stop pattern 394 and the device isolation film 112 may be coplanar with each other, and the plurality of place holders 106 may protrude further than the respective lower surfaces of the etch stop pattern 394 and the device isolation film 112.

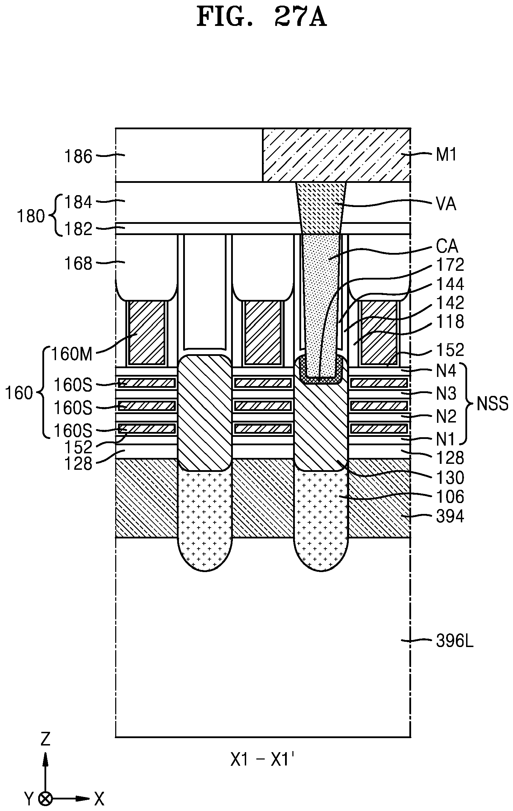

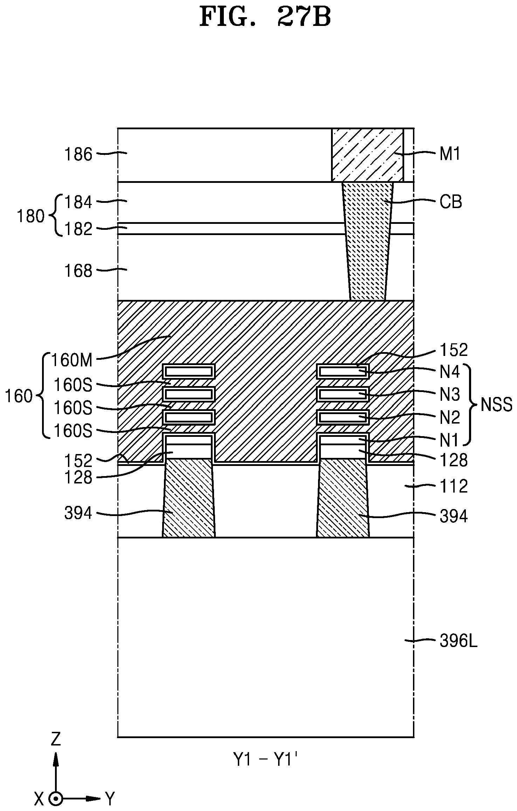

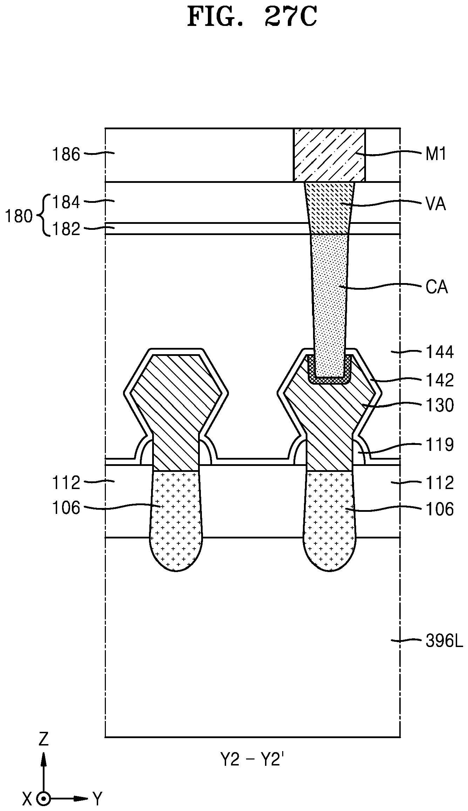

Referring to FIGS. 27A to 27C, in the resulting product of FIGS. 26A to 26C, an outer backside insulating film 396L may be formed to cover the respective lower surfaces of the etch stop pattern 394, the plurality of place holders 106, and the device isolation film 112. A constituent material of the outer backside insulating film 396L is the same as the constituent material of the outer backside insulating pattern 396, which is described with reference to FIGS. 6A to 6C.

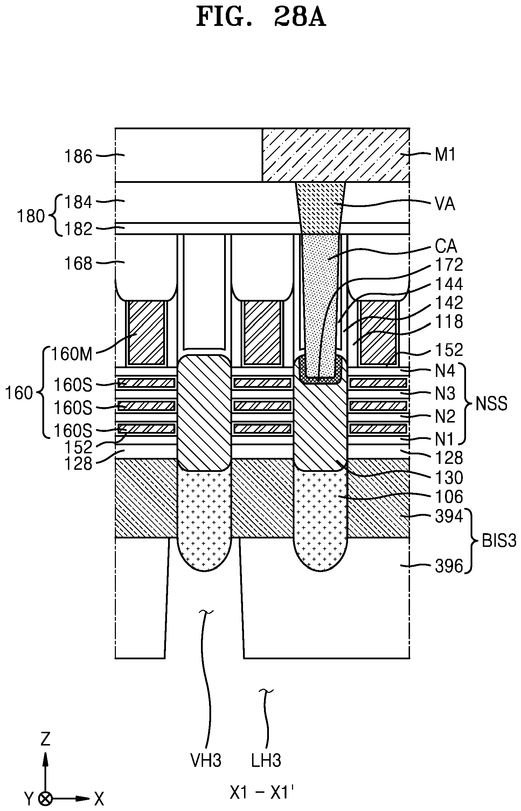

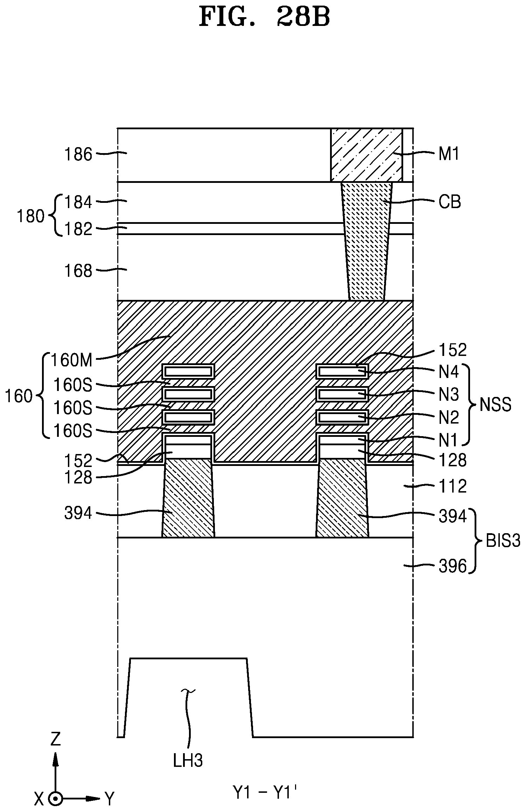

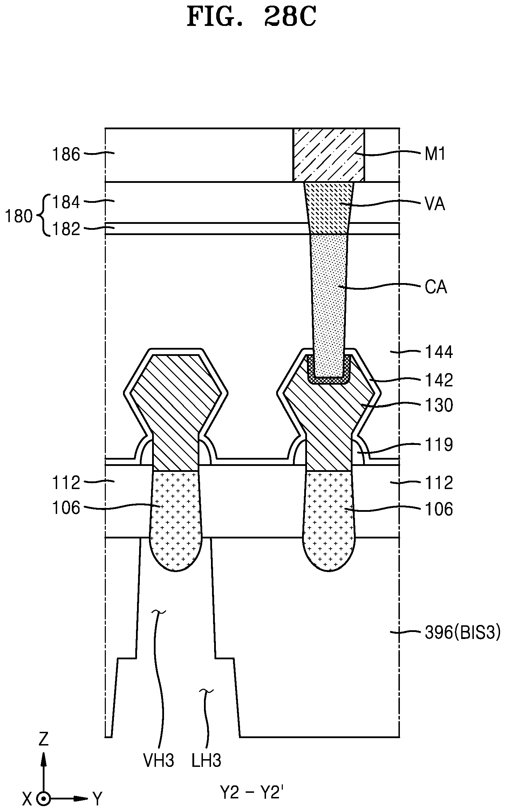

Referring to FIGS. 28A to 28C, a portion of the outer backside insulating film 396L may be etched by using the etch stop pattern 394 as an etch mask, whereby via holes VH3, which respectively expose some place holders 106 selected from the plurality of place holders 106, and line holes LH3, which are respectively connected to the via holes VH3, may be formed. As a result, the outer backside insulating pattern 396, which defines a via hole VH3 and a line hole LH3, may be obtained from the outer backside insulating film 396L. The place holder 106, and a portion of each of the etch stop pattern 394 and the device isolation film 112 therearound may be exposed by the via hole VH3. As shown in FIG. 28C, the length of the line hole LH3 in the vertical direction (Z direction) may be less than the length of the via hole VH3 in the vertical direction (Z direction), and the width of the line hole LH3 in the second horizontal direction (Y direction) may be greater than the width of the via hole VH3 in the second horizontal direction (Y direction).

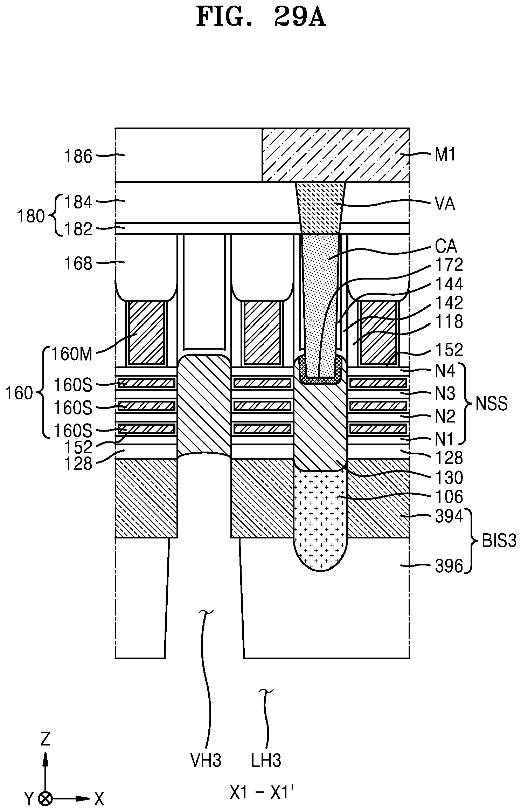

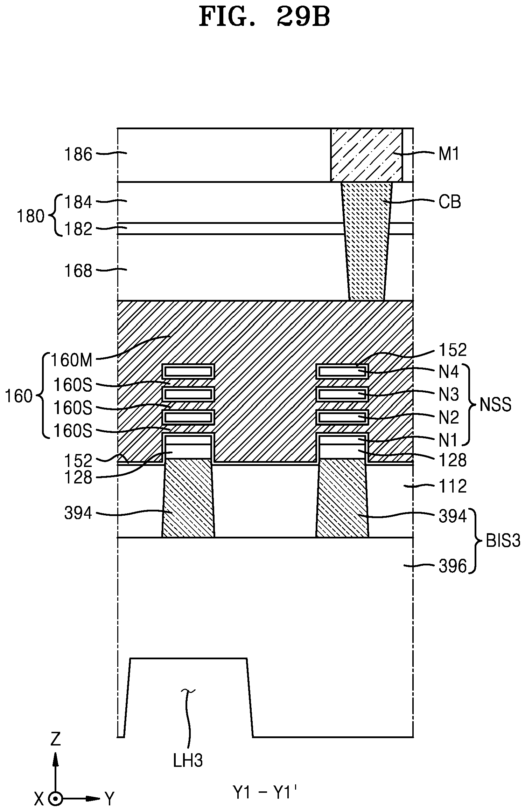

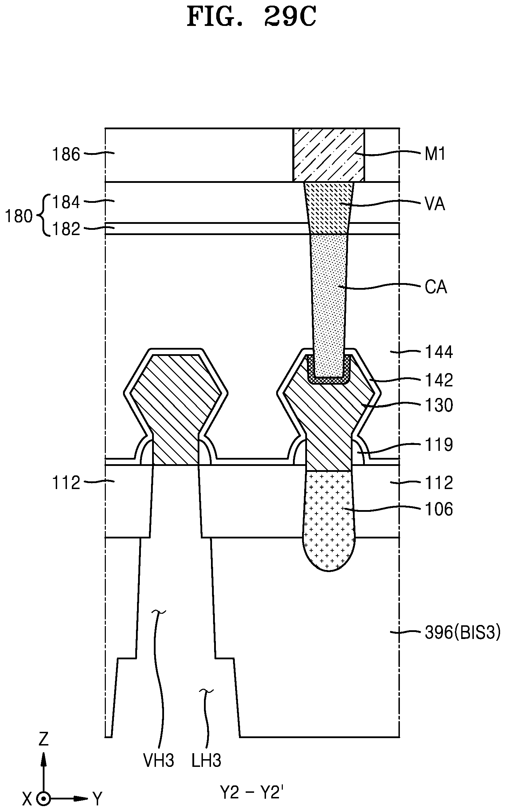

Referring to FIGS. 29A to 29C, the place holder 106, which is exposed by the line hole LH3 and the via hole VH3, may be removed from the resulting product of FIGS. 28A to 28C, thereby exposing the source/drain region 130. While the source/drain region 130 is exposed by removing the place holder 106, a portion of the source/drain region 130 may be etched, and thus, a portion of the source/drain region 130, which is exposed by the via hole VH3, may be reduced in the length thereof in the vertical direction (Z direction).

Next, a conductive material may fill the via hole VH3 and the line hole LH3, thereby forming the backside via contact MPV3 and the backside power rail MPR3, which are shown in FIGS. 6A to 6C.

According to the method of fabricating an integrated circuit device, which is described with reference to FIGS. 9A to 29C, according to various example embodiments, during an etching process for forming the via hole VH or VH3 required or used to form the backside via contact MPV or MPV3, a portion of the outer backside insulating film 196L or 396L is etched by using the etch stop pattern 194 or 394 as an etch mask. Therefore, even though a strict design rule is not used to align the position of the via hole VH or VH3 to an intended target position, the etch stop pattern 194 or 394 may prevent that the via hole VH or VH3 unintentionally reaches up to the gate line 160, the source/drain region 130, or a region adjacent thereto in the integrated circuit device 100 or 300. Therefore, according to the method of fabricating the integrated circuit device 100 or 300, according to various example embodiments, a wiring structure, which is more stable and improved or optimized even in an area reduced due to down-scaling, may be provided, and thus, the integrated circuit device 100 or 300 improved in the degree of integration and the reliability thereof may be fabricated.

Heretofore, although the examples of the methods of fabricating the integrated circuit device 100 shown in FIGS. 2 and 3A to 3C and the integrated circuit device 300 shown in FIGS. 6A to 6C have been described with reference to FIGS. 9A to 29C, it will be understood by those of ordinary skill in the art that the integrated circuit devices 100A, 200, 300A, and 400 respectively shown in FIGS. 4, 5, 7, and 8 be fabricated by making various modifications and changes to the examples described with reference to FIGS. 9A to 29C without departing from the scope of the invention as defined by the claims.

We further define integrated circuit devices as defined by the clauses E1 to E15 below:
E1. An integrated circuit device comprising:
   a backside insulating structure comprising an etch stop pattern;
      a plurality of gate lines over the backside insulating structure and each at least
   partly overlapping the etch stop pattern in a vertical direction;
      a plurality of source/drain regions respectively arranged one-by-one between
   the plurality of gate lines; and
      a backside via contact passing through the etch stop pattern in the vertical direction and connected to a first source/drain region selected from the plurality of source/drain regions,
      wherein the backside via contact comprises a stepped portion apart from a first vertical level in the vertical direction by as much as a first distance and having a change in width in a horizontal direction at a second vertical level that is adjacent to the etch stop pattern, the first vertical level being closest to the plurality of gate lines in the backside insulating structure.
E2. The integrated circuit device of E1, further comprising:
   a place holder at least partly overlapping a second source/drain region in the vertical direction, the second source/drain region selected from the plurality of source/drain regions and apart from the first source/drain region in the horizontal direction, wherein
   the place holder comprises a holder upper surface contacting the second source/drain region, a holder sidewall facing the backside via contact in the horizontal direction with a portion of the backside insulating structure therebetween, and a holder lower surface that is opposite to the holder upper surface in the vertical direction, and
   the holder sidewall and the holder lower surface of the place holder are in contact with the backside insulating structure.
E3. The integrated circuit device of E2, wherein the backside insulating structure further comprises an inner backside insulating pattern between the etch stop pattern and the plurality of gate lines and comprising a different material from any constituent material of the etch stop pattern,
   the holder sidewall of the place holder is in contact with the inner backside insulating pattern, and
   the holder lower surface of the place holder is in contact with the etch stop pattern.
E4. The integrated circuit device of E2, wherein
   the backside insulating structure further comprises an inner backside insulating pattern between the etch stop pattern and the plurality of gate lines and comprising a different material from any constituent material of the etch stop pattern,
   the etch stop pattern comprises a first liner portion, which is in contact with the inner backside insulating pattern, and a second liner portion, which is in contact with the holder lower surface of the place holder, and
   the second liner portion of the etch stop pattern has a cross-sectional shape that is concave toward the place holder.
E5. The integrated circuit device of E2, wherein
   The backside insulating structure further comprises an outer backside insulating pattern apart from the plurality of gate lines in the vertical direction with the etch stop pattern therebetween and comprises a different material from any constituent material of the etch stop pattern,
   the etch stop pattern comprises a gap-fill pattern, which fills a space between the backside via contact and the place holder,
   the holder sidewall of the place holder is in contact with the etch stop pattern, and
   the holder lower surface of the place holder is in contact with the outer backside insulating pattern.
E6. The integrated circuit device of E2, wherein
   the backside insulating structure further comprises an outer backside insulating pattern apart from the plurality of gate lines in the vertical direction with the etch stop pattern therebetween and comprises a different material from any constituent material of the etch stop pattern, and
   the outer backside insulating pattern has a surface that is concave toward the holder lower surface of the place holder.
E7. The integrated circuit device of E1, wherein the backside insulating structure further comprises:
   an inner backside insulating pattern between the etch stop pattern and the plurality of gate lines; and
   an outer backside insulating pattern, which is apart from the inner backside insulating pattern in the vertical direction with the etch stop pattern therebetween,
   each of the inner backside insulating pattern and the outer backside insulating pattern comprises a different material from any constituent material of the etch stop pattern,
   the etch stop pattern comprises a portion extending flat in the horizontal direction around the stepped portion of the backside via contact, and
   a thickness of the etch stop pattern in the vertical direction is less than a thickness of each of the inner backside insulating pattern and the outer backside insulating pattern in the vertical direction.
E8. The integrated circuit device of E7, wherein
   the backside via contact comprises a first contact portion passing through the inner backside insulating pattern, a second contact portion passing through the etch stop pattern, and a third contact portion passing through the outer backside insulating pattern, and,
   in the backside via contact, a sidewall of each of the first contact portion and the third contact portion is not in contact with the etch stop pattern.
E9. The integrated circuit device of E1, wherein
   the backside insulating structure further comprises an outer backside insulating pattern apart from the plurality of gate lines in the vertical direction with the etch stop pattern therebetween and is in contact with the etch stop pattern, the outer backside insulating pattern comprising a different material from any constituent materials of the etch stop pattern, and
   an interface between the etch stop pattern and the outer backside insulating pattern comprises a portion extending flat in the horizontal direction around the stepped portion of the backside via contact.
E10. The integrated circuit device of E9, wherein
   the backside via contact comprises a first contact portion, which passes through the etch stop pattern, and a second contact portion, which passes through the outer backside insulating pattern, and,
   in the backside via contact, a sidewall of the second contact portion is not in contact with the etch stop pattern.
E11. The integrated circuit device of E1, further comprising:
   a place holder apart from the backside via contact in the horizontal direction,
   wherein the place holder is in contact with the etch stop pattern and a second source/drain region, which is selected from the plurality of source/drain regions and is apart from the first source/drain region in the horizontal direction,
   the place holder comprises a first film, which is selected from a doped SiGe film, an undoped SiGe film, an aluminum oxide film, a titanium oxide film, a silicon nitride film, and a combination thereof, and
   the etch stop pattern comprises a second film, which is selected from an aluminum oxide film, a titanium oxide film, a silicon nitride film, and a combination thereof, the second film comprising a different material from any constituent material of the first film.
E12. The integrated circuit device of E1, wherein
   the backside insulating structure further comprises an inner backside insulating pattern arranged between the etch stop pattern and the plurality of gate lines and comprises a different material from any constituent material of the etch stop pattern,
   the backside via contact comprises a first contact portion, which has a sidewall contacting the inner backside insulating pattern, and a second contact portion, which has a sidewall contacting the etch stop pattern, and,
   in the horizontal direction, the width of the second contact portion is greater than the width of the first contact portion.
E13. The integrated circuit device of E1, wherein
   the backside insulating structure further comprises an outer backside insulating pattern, which is apart from the plurality of gate lines in the vertical direction with the etch stop pattern therebetween,
   the backside via contact comprises a first contact portion, which has a sidewall contacting the etch stop pattern, and a second contact portion, which has a sidewall contacting the outer backside insulating pattern, and
   in the horizontal direction, the width of the second contact portion is greater than the width of the first contact portion.
E14. An integrated circuit device comprising:
   a backside insulating structure;
   a plurality of channel regions over the backside insulating structure, the plurality of channel regions being arranged apart from each other in a vertical direction to at least partly overlap each other in the vertical direction;
   a pair of source/drain regions arranged over the backside insulating structure and each contacting the plurality of channel regions;
   a gate line surrounding the plurality of channel regions; and
   a backside via contact passing through the backside insulating structure in the vertical direction and connected to a first source/drain region selected from the pair of source/drain regions,
   wherein the backside insulating structure comprises an etch stop pattern and an outer backside insulating pattern, the etch stop pattern surrounding a portion of the backside via contact and at least partly the gate line in the vertical direction, and the outer backside insulating pattern surrounding another portion of the backside via contact and apart from the gate line in the vertical direction with the etch stop pattern therebetween, the outer backside insulating pattern comprising a different material from any constituent material of the etch stop pattern,
   and wherein the backside via contact comprises a stepped portion apart from a first vertical level in the vertical direction by as much as a first distance and has a change in a width of the backside via contact in a horizontal direction at a second vertical level that is adjacent to the etch stop pattern, the first vertical level being closest to the plurality of gate lines in the backside insulating structure.
E15. The integrated circuit device of E14, further comprising:
   a place holder at least partly overlapping, in the vertical direction, a second source/drain region, which is selected from the pair of source/drain regions and is apart from the first source/drain region in the horizontal direction,
      wherein the place holder comprises a holder upper surface contacting the second source/drain region, a holder sidewall facing the backside via contact in the horizontal direction with a portion of the backside insulating structure therebetween, and a holder lower surface that is opposite to the holder upper surface in the vertical direction, and
   the etch stop pattern is in contact with one selected from the holder sidewall and the holder lower surface of the place holder.

While inventive concepts have been particularly shown and described with reference to embodiments thereof, it will be understood that various changes in form and details may be made therein without departing from the scope of the following claims. Further example embodiments are not necessarily mutually exclusive with one another. For example, some example embodiments may include one or more features described with one or more figures and may also include one or more other features described with reference to one or more other figures.

## Claims

1. An integrated circuit device comprising:
a backside insulating structure comprising an etch stop pattern;
a plurality of gate lines over the backside insulating structure and each at least partly overlapping the etch stop pattern in a vertical direction;
a plurality of source/drain regions respectively arranged one-by-one between the plurality of gate lines; and
a backside via contact passing through the etch stop pattern in the vertical direction and connected to a first source/drain region of the plurality of source/drain regions,
wherein the backside via contact comprises a stepped portion apart from a first vertical level in the vertical direction by a distance and having a change in width in a horizontal direction at a second vertical level that is a vertical level of the etch stop pattern, the first vertical level being closest of the first and second vertical levels to the plurality of gate lines.

2. The integrated circuit device of claim 1, further comprising:
a place holder at least partly overlapping a second source/drain region in the vertical direction, the second source/drain region being one of the plurality of source/drain regions and apart from the first source/drain region in the horizontal direction, wherein
the place holder comprises a holder upper surface contacting the second source/drain region, a holder sidewall facing the backside via contact in the horizontal direction with a portion of the backside insulating structure therebetween, and a holder lower surface that is opposite to the holder upper surface in the vertical direction, and
the holder sidewall and the holder lower surface of the place holder are in contact with the backside insulating structure.

3. The integrated circuit device of claim 2, wherein the backside insulating structure comprises an inner backside insulating pattern between the etch stop pattern and the plurality of gate lines and comprising different material from any constituent material of the etch stop pattern,
the holder sidewall of the place holder is in contact with the inner backside insulating pattern, and
the holder lower surface of the place holder is in contact with the etch stop pattern.

4. The integrated circuit device of claim 2 or 3, wherein
the backside insulating structure comprises an inner backside insulating pattern between the etch stop pattern and the plurality of gate lines and comprising different material from any constituent material of the etch stop pattern,
the etch stop pattern comprises a first liner portion, which is in contact with the inner backside insulating pattern, and a second liner portion, which is in contact with the holder lower surface of the place holder, and
the second liner portion of the etch stop pattern has a cross-sectional shape that is concave toward the place holder.

5. The integrated circuit device of any one of claims 2 to 4, wherein
the backside insulating structure comprises an outer backside insulating pattern apart from the plurality of gate lines in the vertical direction with the etch stop pattern therebetween and comprises different material from any constituent material of the etch stop pattern,
the etch stop pattern comprises a gap-fill pattern, which fills a space between the backside via contact and the place holder,
the holder sidewall of the place holder is in contact with the etch stop pattern, and
the holder lower surface of the place holder is in contact with the outer backside insulating pattern.

6. The integrated circuit device of any one of claims 2 to 5, wherein
the backside insulating structure comprises an outer backside insulating pattern apart from the plurality of gate lines in the vertical direction with the etch stop pattern therebetween and comprises different material from any constituent material of the etch stop pattern, and
the outer backside insulating pattern has a surface that is concave toward the holder lower surface of the place holder.

7. The integrated circuit device of any preceding claim, wherein the backside insulating structure comprises:
an inner backside insulating pattern between the etch stop pattern and the plurality of gate lines; and
an outer backside insulating pattern, which is apart from the inner backside insulating pattern in the vertical direction with the etch stop pattern therebetween,
each of the inner backside insulating pattern and the outer backside insulating pattern comprises different material from any constituent material of the etch stop pattern,
the etch stop pattern comprises a portion extending flat in the horizontal direction around the stepped portion of the backside via contact, and
a thickness of the etch stop pattern in the vertical direction is less than a thickness of each of the inner backside insulating pattern and the outer backside insulating pattern in the vertical direction.

8. The integrated circuit device of claim 7, wherein
the backside via contact comprises a first contact portion passing through the inner backside insulating pattern, a second contact portion passing through the etch stop pattern, and a third contact portion passing through the outer backside insulating pattern, and,
in the backside via contact, a sidewall of each of the first contact portion and the third contact portion is not in contact with the etch stop pattern.

9. The integrated circuit device of any preceding claim, wherein
the backside insulating structure comprises an outer backside insulating pattern apart from the plurality of gate lines in the vertical direction with the etch stop pattern therebetween and is in contact with the etch stop pattern, the outer backside insulating pattern comprising different material from any constituent materials of the etch stop pattern, and
an interface between the etch stop pattern and the outer backside insulating pattern comprises a portion extending flat in the horizontal direction around the stepped portion of the backside via contact.

10. The integrated circuit device of claim 9, wherein
the backside via contact comprises a first contact portion, which passes through the etch stop pattern, and a second contact portion, which passes through the outer backside insulating pattern, and,
in the backside via contact, a sidewall of the second contact portion is not in contact with the etch stop pattern.

11. The integrated circuit device of any preceding claim, comprising:
a place holder apart from the backside via contact in the horizontal direction,
wherein the place holder is in contact with the etch stop pattern and a second source/drain region, which is one of the plurality of source/drain regions and is apart from the first source/drain region in the horizontal direction,
the place holder comprises a first film, which comprises at least one of a doped SiGe film, an undoped SiGe film, an aluminum oxide film, a titanium oxide film and/or a silicon nitride film, and
the etch stop pattern comprises a second film, which comprises at least one of an aluminum oxide film, a titanium oxide film and/or a silicon nitride film, the second film comprising different material from any constituent material of the first film.

12. The integrated circuit device of any preceding claim, wherein
the backside insulating structure comprises an inner backside insulating pattern arranged between the etch stop pattern and the plurality of gate lines and comprises different material from any constituent material of the etch stop pattern,
the backside via contact comprises a first contact portion, which has a sidewall contacting the inner backside insulating pattern, and a second contact portion, which has a sidewall contacting the etch stop pattern, and,
in the horizontal direction, the width of the second contact portion is greater than the width of the first contact portion.

13. The integrated circuit device of any preceding claim, wherein
the backside insulating structure comprises an outer backside insulating pattern, which is apart from the plurality of gate lines in the vertical direction with the etch stop pattern therebetween,
the backside via contact comprises a first contact portion, which has a sidewall contacting the etch stop pattern, and a second contact portion, which has a sidewall contacting the outer backside insulating pattern, and
in the horizontal direction, the width of the second contact portion is greater than the width of the first contact portion.

14. An integrated circuit device of any preceding claim, comprising:
a backside insulating structure;
a plurality of channel regions over the backside insulating structure, the plurality of channel regions being arranged apart from each other in a vertical direction to at least partly overlap each other in the vertical direction;
a pair of source/drain regions arranged over the backside insulating structure and each contacting the plurality of channel regions;
a gate line surrounding the plurality of channel regions; and
a backside via contact passing through the backside insulating structure in the vertical direction and connected to a first source/drain region of the pair of source/drain regions,
wherein the backside insulating structure comprises an etch stop pattern and an outer backside insulating pattern, the etch stop pattern surrounding a portion of the backside via contact and at least partly the gate line in the vertical direction, and the outer backside insulating pattern surrounding another portion of the backside via contact and apart from the gate line in the vertical direction with the etch stop pattern therebetween, the outer backside insulating pattern comprising different material from any constituent material of the etch stop pattern,
and wherein the backside via contact comprises a stepped portion apart from a first vertical level in the vertical direction by a distance and has a change in a width of the backside via contact in a horizontal direction at a second vertical level that is a vertical level of the etch stop pattern, the first vertical level being closest of the first and second vertical levels to the plurality of gate lines.

15. The integrated circuit device of claim 14, comprising:
a place holder at least partly overlapping, in the vertical direction, a second source/drain region, which is one of the pair of source/drain regions and is apart from the first source/drain region in the horizontal direction,
wherein the place holder comprises a holder upper surface contacting the second source/drain region, a holder sidewall facing the backside via contact in the horizontal direction with a portion of the backside insulating structure therebetween, and a holder lower surface that is opposite to the holder upper surface in the vertical direction, and
the etch stop pattern is in contact with either the holder sidewall or the holder lower surface of the place holder.
